# EUROPÄISCHE PATENTSCHRIFT

(11) **EP 2 729 477 B1**
(45) Veröffentlichungstag und Bekanntmachung des Hinweises auf die Patenterteilung: **20.01.2016**
(21) Anmeldenummer: 12745416.3
(22) Anmeldetag: 09.07.2012
(51) Int. Cl.: C07F 9/50, C07F 1/00, C09K 11/06, H01L 51/50, H01L 51/56, H01L 51/00

(54) **KUPFER (I) KOMPLEXE FÜR OPTO-ELEKTRONISCHE VORRICHTUNGEN**
COPPER(I) COMPLEXES FOR OPTOELECTRONIC DEVICES
COMPLEXES DE CUIVRE (I) POUR DISPOSITIFS OPTO-ÉLECTRONIQUES

(30) Priorität: 08.07.2011 EP 11173371; 05.08.2011 EP 11176760; 26.08.2011 EP 11179112
(43) Veröffentlichungstag der Anmeldung: 14.05.2014
(73) Patentinhaber: cynora GmbH, 76646 Bruchsal (DE)
(72) Erfinder: BAUMANN, Thomas, 76133 Karlsruhe (DE); GRAB, Tobias, 76133 Karlsruhe (DE); BERGMANN, Larissa, 76133 Karlsruhe (DE)
(74) Vertreter: Hoppe, Georg Johannes
(86) Internationale Anmeldenummer: PCT/EP2012/063444
(87) Internationale Veröffentlichungsnummer: WO 2013/007707

(56) Entgegenhaltungen:
- WO-A1-2010/031485

## Beschreibung

Die vorliegende Erfindung betrifft die Verwendung von Kupfer(I)komplexen (Cu(I)-Komplexen) als Emitter in OLEDs (organic light emitting diodes) und in anderen optoelektronischen Vorrichtungen.

### Einleitung

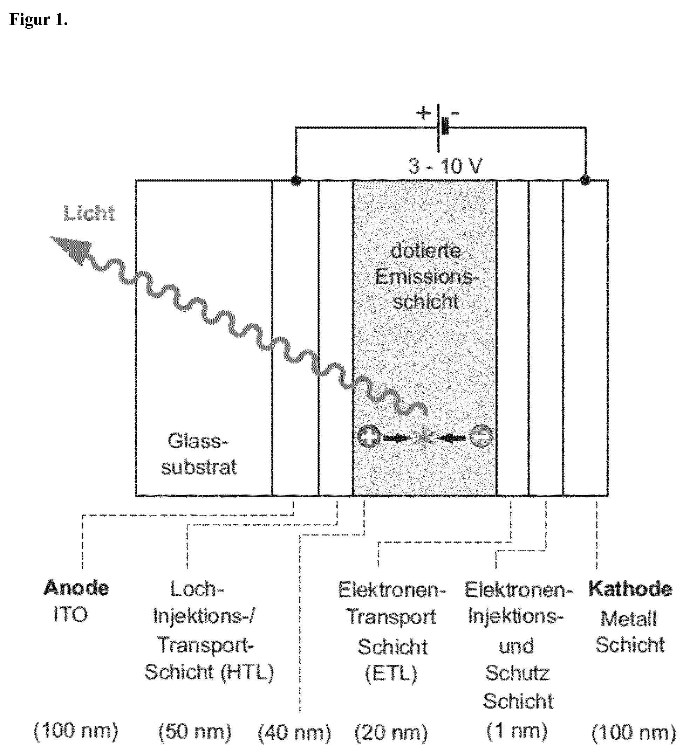

OLEDs eignen sich prinzipiell hervorragend zur Herstellung großflächiger Beleuchtungs- und Displayanwendungen, finden sich im Augenblick aufgrund aufwendiger Herstellungsverfahren jedoch nur in kleinformatigen Geräten wieder. OLEDs werden in der Regel in Schichtenstrukturen realisiert. Zum besseren Verständnis ist in Fig. 1 ein prinzipieller Aufbau eines OLEDs gezeigt. Aufgrund der angelegten äußeren Spannung an einer transparenten Indium-Zinn-Oxid-Anode (ITO) und einer dünnen Metall-Kathode werden von der Anode positive Löcher und von der Kathode negative Elektronen injiziert. Diese verschieden geladenen Ladungsträger gelangen über Zwischenschichten, zu denen auch hier nicht gezeichnete Loch- bzw. Elektronen-Blockierschichten gehören können, in die Emissionsschicht. Dort treffen die entgegengesetzt geladenen Ladungsträger an oder in der Nähe von dotierten Emitter-Molekülen zusammen und rekombinieren. Die Emitter-Moleküle sind in der Regel in Matrix-Molekülen oder Polymermatrizen (in z. B. 2 bis 10 Gew.-%) eingelagert, wobei die Matrix-Materialien so gewählt sind, dass sie auch einen Loch- und Elektronentransport ermöglichen. Durch die Rekombination entstehen Exzitonen (= Anregungszustände), die ihre Überschussenergie auf die jeweilige elektrolumineszierende Verbindung übertragen. Diese elektrolumineszierende Verbindung kann daraufhin in einen bestimmten elektronischen Anregungszustand übergehen, der dann möglichst vollständig und unter weitgehender Vermeidung strahlungsloser Desaktivierungsprozesse durch Lichtemission in den zugehörigen Grundzustand umgewandelt wird.

Als elektronischer Anregungszustand, der auch durch Energieübertragung von einem geeigneten Vorläufer-Exziton gebildet werden kann, kommt, von wenigen Ausnahmen abgesehen, entweder ein Singulett- oder ein Triplett-Zustand, bestehend aus drei Unterzuständen, in Betracht. Da beide Zustände aufgrund der Spinstatistik in der Regel im Verhältnis 1:3 besetzt werden, ergibt sich, dass bei einer Emission aus dem Singulett-Zustand, die als Fluoreszenz bezeichnet wird nur maximal 25 % der erzeugten Exzitonen wieder zur Emission führen. Dagegen können bei einer Triplett-Emission, die als Phosphoreszenz bezeichnet wird, sämtliche Exzitonen ausgenutzt, umgewandelt und als Licht emittiert werden (Triplett-Harvesting), so dass in diesem Fall die Innere Quantenausbeute den Wert von 100 % erreichen kann, sofern der mit angeregte und energetisch über dem Triplett-Zustand liegende Singulett-Zustand vollständig in den Triplett-Zustand relaxiert (Inter-System-Crossing, ISC) und strahlungslose Konkurrenzprozesse bedeutungslos bleiben. Somit sind Triplett-Emitter nach dem bisherigen Stand der Technik effizientere Elektro-Luminophore und besser geeignet, in einer organischen Leuchtdiode für eine hohe Lichtausbeute zu sorgen.

Bei den für das Triplett-Harvesting geeigneten Triplett-Emittern werden in der Regel Übergangsmetall-Komplexverbindungen eingesetzt, in denen das Metall aus der dritten Periode der Übergangsmetalle gewählt wird. Hierbei handelt es sich vorwiegend um sehr teure Edelmetalle wie Iridium, Platin oder auch Gold (siehe dazu auch H. Yersin, Top. Curr. Chem. 2004, 241, 1 und M. A. Baldo, D. F. O'Brien, M. E. Thompson, S. R. Forrest, Phys. Rev. B 1999, 60, 14422). Der wesentliche Grund dafür liegt in der hohen Spin-Bahn-Kopplung (SBK) der Edelmetall-Zentralionen (SBK-Konstante Ir(III): ≈ 4000 cm⁻¹; Pt(II): ≈ 4500 cm⁻¹; Au(I): ≈ 5100 cm⁻¹; Ref.: S. L. Murov, J. Carmicheal, G. L. Hug, Handbook of Photochemistry, 2nd Edition, Marcel Dekker, New York 1993, p. 338 ff). Durch diese quantenmechanische Eigenschaft wird der ohne SBK für optische Übergänge strikt verbotene Triplett-Singulett-Übergang erlaubt und die für die OLED-Anwendung erforderliche kurze Emissionslebensdauer von wenigen µs erreicht.

Es wäre von großem wirtschaftlichen Vorteil, wenn diese teuren Edelmetalle durch preiswerte Metalle ersetzt werden könnten. Darüber hinaus ist eine Vielzahl der bisher bekannten OLED-Emitter-Materialien aus ökologischer Sicht nicht unbedenklich, so dass die Verwendung von weniger toxischen Materialien wünschenswert wäre. Ein derartiger Ansatz findet sich auch in der WO2010/031485 A1.

### Beschreibung der Erfindung

Die Erfindung betrifft die Schaffung und Bereitstellung neuer Cu(I)-Verbindungen mit verbesserten Eigenschaften. Insbesondere weisen diese Cu(I)-Verbindungen die folgenden Eigenschaften auf:
- relativ kurze Emissionslebensdauer, insbesondere von nur wenigen µs,
- hohe Emissionsquantenausbeuten größer 40 %,
- weitgehende Verhinderung von unerwünschten Geometrie-Veränderungen und/oder
- Löslichkeit in verschiedenen, den technologischen Anforderungen genügenden Lösungsmitteln.

Zu den organischen Lösungsmitteln im Sinne der Erfindung gehören
- Alkane, auch halogenierte Alkane wie Pentan, Hexan, Heptan, einschließlich verzweigter Alkane,
- Dichlormethan, Chloroform, 1,2-Dichlorethan, 1,1,1-Trichlorethan, Tetrachlorkohlenstoff, Perchlorethylen
- Aromatische Kohlenwasserstoffe, auch halogeniert: Benzol, Toluol, Mesitylen, Chlorbenzol, 1,2-Dichlorbenzol
- Ether: Tetrahydrofuran, Diethylether, Phenetol
- Ketone: Aceton, Methylethylketon, Propiophenon
- sowie: Acetonitril, Nitromethan, Dimethylsulfoxid, Dimethylformamid, Methanol, Ethanol und Essigsäureethylester.

In bevorzugten Ausgestaltungen der Erfindung ist der Kupfer(I)komplex insbesondere in mindestens einem der folgenden Lösungsmittel gut löslich: polaren Kohlenwasserstoffe wie z. B. Dichlormethan, Chloroform, 1,2-Dichlorethan, 1,1,1-Trichlorethan, Perchlorethylen, Toluol, Mesitylen, Chlorbenzol, 1,2-Dichlorbenzol, Tetrahydrofuran, Diethylether, Phenetol, Aceton, Methylethylketon, Propiophenon, Nitromethan, Dimethylsulfoxid, Dimethylformamid, Methanol und Ethanol.

### Stabilisierung der Molekularstruktur

Vierfach koordinierte Cu(I) Komplexe weisen im elektronischen Grundzustand eine annähernd tetraedrische Koordination des Metallatoms auf. Bei Anregung in einen elektronischen angeregten Zustand mit ausgeprägtem Metall-zu-Ligand-Charge-Transfer Charakter und der damit verbundenen formalen Oxidierung des Metallatoms zu Cu(II) kann es zu wesentlichen Veränderungen der Geometrie des Komplexes in Richtung einer quadratisch-planaren Koordination kommen, was daher als "Planarisierung" des Komplex-Moleküls bezeichnet werden kann. Dieser Prozess liefert einen sehr effektiven Mechanismus für das Löschen (Quenchen) der Lumineszenz.

In den erfindungsgemäßen Kupfer(I)komplexen wird dieser Löschmechanismus durch Anwesenheit sterisch anspruchvoller Substituenten am einfach negativ geladenen Ligand N∩L (insbesondere in den ortho-Positionen zu den Koordinationsstellen) verhindert oder sehr reduziert durch eine Verhinderung der Geometrie-Veränderungen um das Cu-Atom. Gleichzeitig tragen derartige Substitutionen zum Schutz des Cu-Zentrums vor unerwünschten chemischen Reaktionen mit nukleophilen Substanzen (Lösungsmitteln, Verunreinigungen, leicht koordinierenden Matrixmaterialien) bei. Bereits eine Methylgruppe führt zu einer merklichen "Versteifung" der resultierenden Cu-Komplexe. Ein sterisch anspruchsvoller Substituent ist daher neben Methyl insbesondere ein Alkylrest -(CH₂)ₙ-CH₃ (n = 0 - 20) (auch verzweigt), ein Arylrest mit 6 - 20 Kohlenstoffatomen (z. B. -Ph), Alkoxyrest -O-(CH₂)ₙ-CH₃ (n = 0 - 20), ein Aryloxyrest (z. B. -OPh) oder ein Silanrest (z. B -SiMe₃). Die Alkyl- und Arylreste können auch substituiert sein (z. B. mit Halogenen, Deuterium, Alkoxy- oder Silan-Gruppen, usw.) oder zu annelierten Ringsystemen führen.

### Chemische Leitstruktur

Der erfindungsgemäße Emitter ist ein Emitter umfassend Formel **1:** 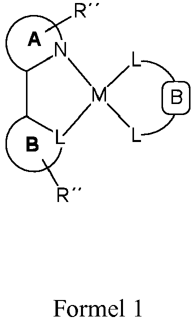 wobei

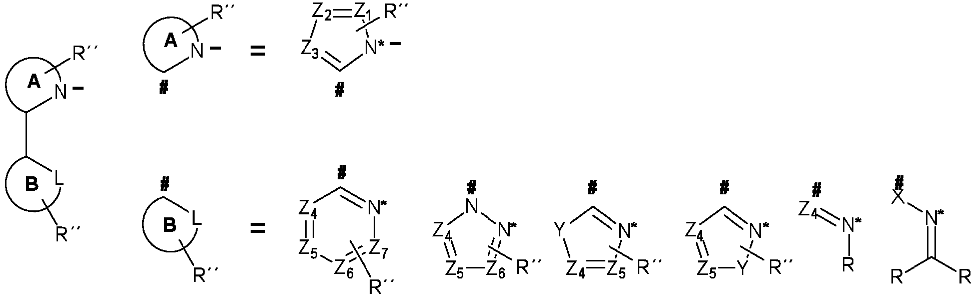

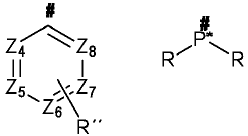

Darin bedeuten:
- M ist Cu(I).
- Bei L-B-L handelt es sich um einen neutralen, zweizähnigen Liganden. Bevorzugt ist L ein Phosphanyl- oder Arsanyl-Rest E*(R1)(R2), mit E = P oder As; R1, R2 können jeweils unabhängig voneinander Wasserstoff, Halogen oder Deuterium sein oder Substituenten, die über Sauerstoff- (-OR"'), Stickstoff- (-NR"'₂) oder Siliziumatome (-SiR"'₃) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen, der über eine Brücke B mit einem weiteren Rest L verbunden ist und damit einen zweizähnigen Liganden bildet, wobei die Brücke B eine Alkylen- oder Arylen-Gruppe oder eine Kombination beider, oder-O-, -NR"'- oder -SiR"'₂- ist. Die Gruppen R1-R2 können auch zu anellierten Ringsystemen führen.
- Z1-Z7 besteht aus N oder dem Fragment CR,
   mit R = organischer Rest, der ausgewählt ist aus der Gruppe bestehend aus: Wasserstoff, Halogen oder Deuterium oder Gruppen, die über Sauerstoff- (-OR''), Stickstoff- (-NR"'₂), Silizium- (-SiR"'₃) oder Phosphoratome (-PR"'₂) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen.
- X ist entweder CR"'₂ oder NR"'.
- Y ist entweder O, S oder NR"'.
- Z8 besteht dem Fragment CR',
   mit R' = O*R"', N*R"'₂ oder P*R""₂, wobei die Bindung zum Cu-Atom dann über diese Gruppen erfolgt.
- R" ist ein sterisch anspruchsvoller Substituent bevorzugt in ortho-Position zur Koordinationsstelle, der eine Geometrieveränderung in Richtung einer Planarisierung des Komplexes im angeregten Zustand verhindert. Ein sterisch anspruchsvoller Substituent ist insbesondere ein Alkylrest -(CH₂)ₙ-CH₃ (n = 0 - 20) (auch verzweigt), ein Arylrest mit 6 - 20 Kohlenstoffatomen (z. B. -Ph), Alkoxyrest -O-(CH₂)ₙ-CH₃ (n = 0 - 20), ein Aryloxyrest (z. B. -OPh) oder ein Silanrest (z. B -SiMe₃). Die Alkyl- und Arylreste können auch substituiert sein (z. B. mit Halogenen, Deuterium, Alkoxy- oder Silan-Gruppen, usw.) oder zu annelierten Ringsystemen führen. Obwohl in der Formel A zwei Reste R" dargestellt sind, kann ein erfindungsgemäßer Komplex in einer Ausführungsform der Erfindung auch keinen oder nur einen Rest R" aufweisen.
- R'" = organischer Rests, der ausgewählt ist aus der Gruppe bestehend aus: Wasserstoff, Halogen oder Deuterium, sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen
- Zusätzlich kann der Komplex optional eine Funktions-Gruppe (FG) aufweisen. Dabei handelt es sich um einen weiteren Substituenten, der eine zusätzliche Funktion in den Komplex einbringt, den dieser ansonsten nicht aufweisen würde. Die Funktions-Gruppen FG werden entweder direkt oder über geeignete Brücken (siehe unten) an die N∩L -Substituenten angebracht.
   - Dabei kann es sich entweder um eine Gruppe handeln, die Eigenschaften eines Elektronenleiters besitzt.
   - Es kann sich um eine Gruppe handeln, die Eigenschaften eines Lochleiters aufweist.
   - Es kann sich um einen Gruppe handeln, die die Löslichkeit des Komplexes bestimmt.
- "*" kennzeichnet das Atom, das die Komplexbindung eingeht.
- "#" kennzeichnet das Atom, das mit der zweiten Einheit verbunden ist.

Eine bevorzugte Ausgestaltung der Erfindung umfasst die stabilen Emitter der Formel A, die sich durch eine besondere Stabilität auszeichnen: 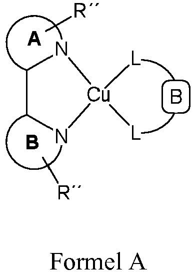 wobei 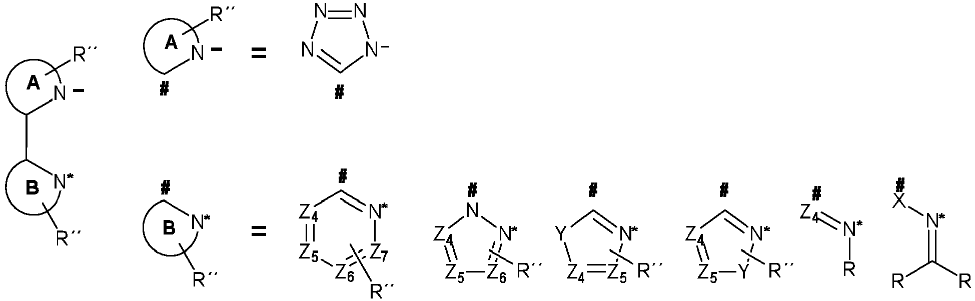 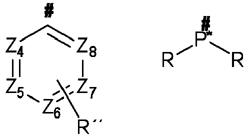 wobei gilt:
- M ist Cu(I);
- L-B-L: ein neutraler, zweizähniger Ligand, bevorzugt ein Phosphanyl- oder Arsanyl-Rest E*(R1)(R2), mit E = P oder As; R1, R2 können jeweils unabhängig voneinander Wasserstoff, Halogen oder Deuterium sein oder Substituenten, die über Sauerstoff- (-OR"'), Stickstoff- (-NR"'₂) oder Siliziumatome (-SiR'"₃) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen, der über eine Brücke B mit einem weiteren Rest L verbunden ist und damit einen zweizähnigen Liganden bildet, wobei die Brücke B eine Alkylen- oder Arylen-Gruppe oder eine Kombination beider, oder -O-, -NR"'- oder -SiR'"₂- ist, wobei die Gruppen R1-R2 optional anellierte Ringsysteme bilden;
- Z4-Z7: besteht aus N oder dem Fragment CR,
   mit R = organischer Rest, der ausgewählt ist aus der Gruppe bestehend aus: Wasserstoff, Halogen oder Deuterium oder Gruppen, die über Sauerstoff- (-OR''), Stickstoff- (-NR"'₂), Silizium- (-SiR"'₃) oder Phosphoratome (-PR"'₂) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen;
- X ist entweder CR'''₂ oder NR"';
- Y ist entweder O, S oder NR"';
- Z8 besteht aus dem Fragment CR',
   mit R' = OR"', NR"'₂ oder PR'"₂, wobei die Bindung zum Cu-Atom dann über diese Gruppen erfolgt;
- R" ist ein sterisch anspruchsvoller Substituent, bevorzugt in ortho-Position zur Koordinationsstelle, der eine Geometrieveränderung in Richtung einer Planarisierung des Komplexes im angeregten Zustand verhindert, bevorzugt ein Alkylrest -(CH₂)ₙ-CH₃ (n = 0 - 20) (auch verzweigt), ein Arylrest mit 6 - 20 Kohlenstoffatomen (z. B. - Ph), Alkoxyrest -O-(CH₂)ₙ-CH₃ (n = 0 - 20), ein Aryloxyrest (z. B. -OPh) oder ein Silanrest (z. B -SiMe₃), wobei die Alkyl- und Arylreste auch substituiert sein können (z. B. mit Halogenen, Deuterium, Alkoxy- oder Silan-Gruppen) und optional zu annelierten Ringsystemen führen,
   wobei Formel A keinen, einen oder zwei Reste R" aufweist;
- R'" = organischer Rest, der ausgewählt ist aus der Gruppe bestehend aus: Wasserstoff, Halogen oder Deuterium, sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen
- optional kann der Kupfer(I)komplex eine FG = Funktions-Gruppe (FG) als weiteren Substituenten aufweisen, die entweder direkt oder über geeignete Brücken an den N∩L -Substituenten gebunden ist, wobei die Funktionsgruppe ausgewählt ist aus der Gruppe bestehend aus Elektronenleiter, Lochleiter und Gruppen, die die Löslichkeit des Komplexes verändern, insbesondere die Löslichkeit in organischen Lösungsmitteln erhöhen;
- "*" kennzeichnet das Atom, das die Komplexbindung eingeht; und
- "#" kennzeichnet das Atom, das die Bindung mit der zweiten chemischen Einheit vermittelt;
- wobei der Kupfer(I)komplex optional
   - einen ΔE(S₁-T₁)-Wert zwischen dem untersten angeregten Singulett (S₁)- und dem darunter liegenden Triplett (T₁)-Zustand von kleiner als 2500 cm⁻¹ aufweist;
   - eine Emissionslebensdauer von höchstens 20 µs aufweist;
   - eine Emissionsquantenausbeuten von größer 40 % aufweist, und/oder
   - eine Löslichkeit in organischen Lösungsmitteln von mindestens 1 g/L aufweist.

### Definition des N∩L Liganden

Bei dem einfach negativ geladenen Liganden N∩L handelt es sich bevorzugt um eines der nachfolgend dargestellten Moleküle:

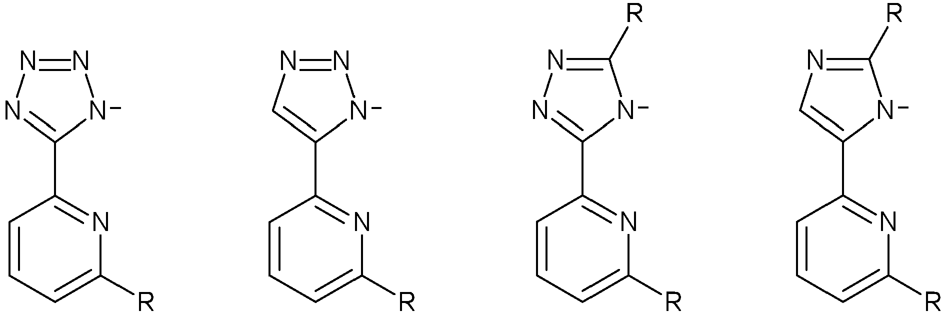

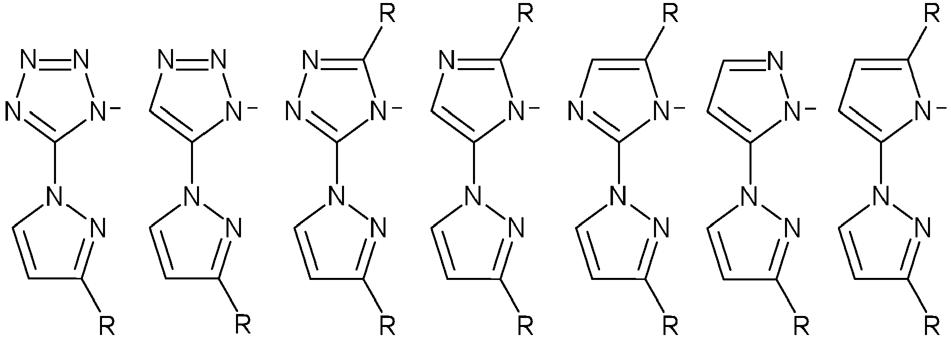

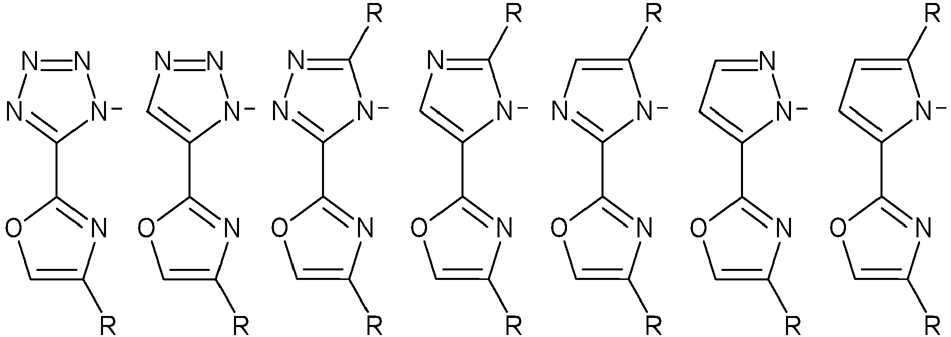

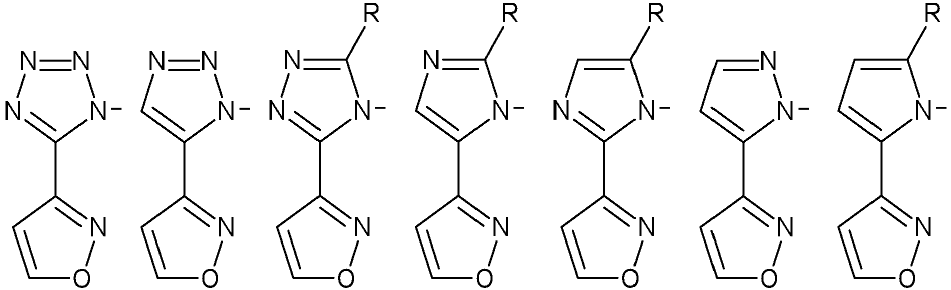

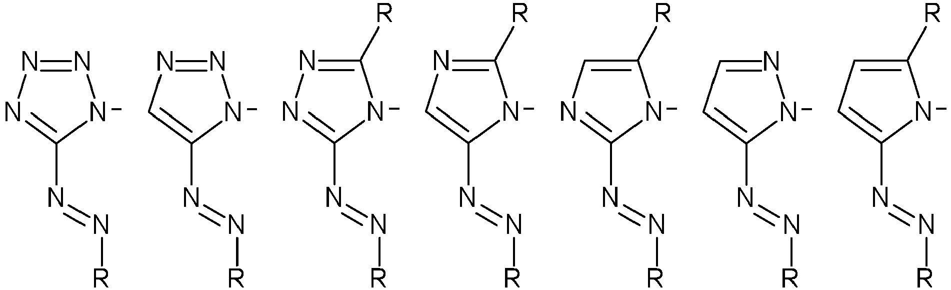

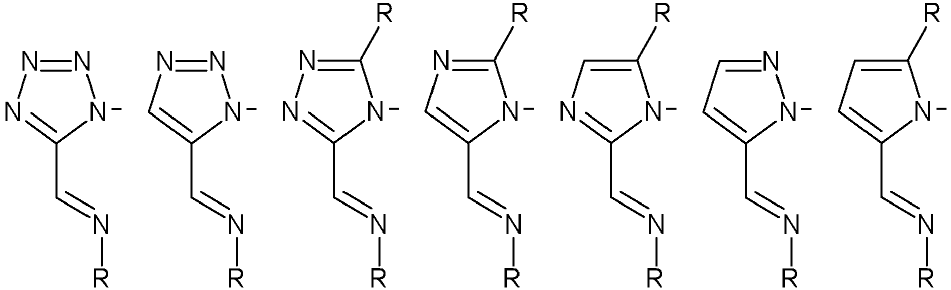

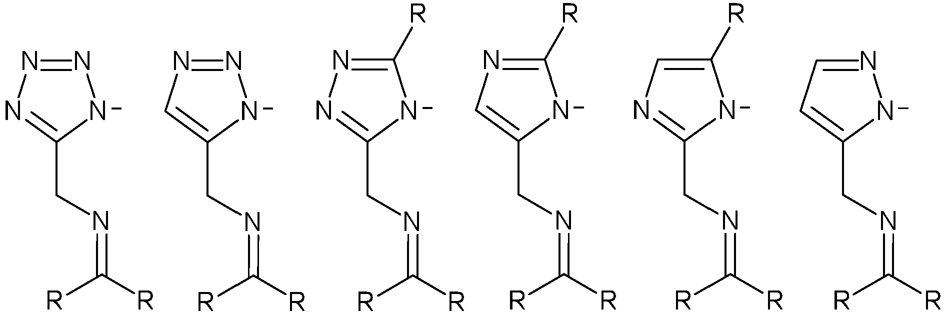

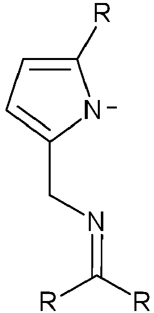

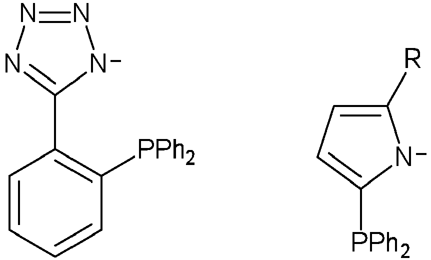

Bei den Substituenten R kann es sich es sich um ein Alkyl-Rest [CH₃-(CH₂)ₙ-] (n = 1 - 20), der auch verzweigt oder mit Halogenen (F, Cl, Br, I) oder Deuterium substituiert sein kann oder um einen Aryl-Rest (insbesondere Phenyl) handeln, der mit Alkyl-Gruppen, Halogenen (F, Cl, Br, I), Deuterium, Silan- (-SiR'₃) oder Ethergruppen -OR' (R' definiert wie R) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Deuterium, Silan- (-SiR"₃) oder Ethergruppen -OR" (R" definiert wie R) substituiert sein können. Bei R kann es sich aber auch um ein Wasserstoffatom oder Deuterium handeln. In einer bevorzugten Ausführungsform der Erfindung entspricht der Substituent R des N∩L Liganden dem sterisch anspruchsvollen Substituenten R" der Formel A.

In einer bevorzugten Ausführung der Erfindung entspricht der A-Ring des N∩L-Liganden einem Tetrazolring. In mononuklearen, neutralen Komplexen überwiegen im Vergleich zu kationischen Kupfer(I)-Komplexen die elektronischen Einflüsse der Liganden auf die Komplexstruktur und die Lumineszenzeigenschaften: So erhöht der anionische Ligand gegenüber einem neutralen Liganden die Elektronendichte am Kupfer(I)-Atom und hebt damit dessen HOMO an, was zu einer größeren Oxidationsempfindlichkeit führt (T. McCormick, W. L. Jia, S. Wang, Inorg. Chem. 2006, 45, 147 - 55. *Phosphorescent Cu(I)Complexes of 2-(2'-pyridylbenzimidazolyl)benzene: Impact of Phosphine Ancillary Ligands on Electronic and Photophysical Properties of the Cu(I)Complexes*). Um eine starke Koordination und damit eine starre Komplexstruktur, die für hohe Quantenausbeuten unabdingbar ist, zu bewirken, dürfen die Donorzentren des anionischen Liganden eine möglichst geringe Elektronendichte induzieren. Das bedeutet für die Ligandenstruktur, dass die negative Ladung entweder an einem nicht koordinierenden Atom sitzt, oder über Mesomerie delokalisiert sein sollte. Bekannt für die Delokalisierung der negativen Ladung nach Deprotonierung sind Tetrazole, die dementsprechend hohe Aziditäten mit pKₐ ≈ 3 - 5 aufweisen. Dies wiederum begünstigt die Synthese der Komplexe, da mit einer milderen Base gearbeitet werden kann und somit weniger Nebenreaktionen auftreten. Anstelle des Modells der Orbitallagen kann auch auf das HSAB-Konzept nach Pearson zurückgegriffen werden, nachdem das koordinierende Zentrum des anionischen Liganden möglichst weich, d.h. die negative Ladung delokalisiert sein sollte, um eine starke Koordination zum weichen Cu(I)-Atom auszubilden.

Der N∩L Ligand kann an geeigneten Stellen mit mindestens einer Funktions-Gruppe FG substituiert sein. So können sich direkte C_{FG}-C_{NN} Bindungen bilden, wobei C_{NN} ein C-Atom des N∩L Liganden darstellt und C_{FG} ein C-Atom der Funktions-Gruppe. Ist das anbindende Atom ein Stickstoffatom, so ergeben sich N_{FG}-C_{NN} Bindungen, wobei N_{FG} für das Stickstoffatom steht. Andererseits kann die Funktions-Gruppe über eine Brücke an den N∩L Liganden angeknüpft werden, wobei sich z. B. Ether-, Thioether-, Ester-, Amid-, Methylen-, Silan-, Ethylen-, Ethin-Brücken anbieten. Damit können sich als Brücken beispielsweise folgende Funktionen ergeben: C_{FG}-O-C_{NN}, C_{FG}-S-C_{NN}, -C_{FG}-C(O)-O-C_{NN}-, C_{FG}-C(O)-NH-C_{NN}-, C_{FG}-CH₂-C_{NN}, C_{FG}-SiR'₂-C_{NN}, C_{FG}-CH=CH-C_{NN}, C_{FG}-C≡C-C_{NN},N_{FG}-CH₂-C_{NN}.

Die Verfahren zur Verknüpfung der Funktionsgruppe an den N∩L Ligand, entweder direkt oder über eine Brücke, sind dem Fachmann bekannt (Suzuki-, Still-, Heck-, Sonogashira-, Kumuda-, Ullmann-, Buchwald-Hartwig-Kupplung sowie deren Varianten; (Thio)Veretherung, Veresterung, nucleophile und elektrophile Substitutionen am sp³-Kohlenstoff oder Aromaten, usw.). Beispielsweise illustriert der in der Literatur beschriebene Ligand (4,4'-Bis(5-(hexylthio)-2,2'-bithien-5'-yl)-2,2'-bipyridine) die Möglichkeit einer Anbindung eines elektronenleitenden Substituenten an einen bpy Liganden mittels einer Stille Kupplung (C.-Y. Chen, M. Wang, J.-Y. Li, N. Pootrakulchote, L. Alibabaei, C.-h. Ngoc-le, J.-D. Decoppet, J.-H. Tsai, C. Grätzel, C.-G. Wu, S. M. Zakeeruddin, M. Grätzel, ACS Nano 2009,3,3103).

Eine weitere Möglichkeit zur Synthese substituierter N∩L Liganden besteht in der Kupplung zweier, bereits mit dem Rest R sowie der Funktions-Gruppe FG substituierter N- und L-Ringe. Die sich hieraus ergebende N∩L-Liganden können daher auch asymmetrisch substituiert sein. Die Verfahren und relevante Literatur sind im Übersichtsartikel von G. Chelucci (G. Chelucci, R. P. Thummel, Chem. Rev. 2002, 102, 3129) zusammengefasst.

In einer besonderen Ausführungsform kann der Rest R auch ein elektronenleitender, lochleitender oder die Löslichkeit erhöhender Substituent sein.

### Definition des L-B-L Liganden

Bei dem neutralen L-B-L-Liganden kann es sich um eines der unten dargestellten Moleküle handeln:

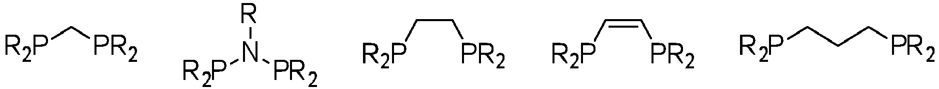

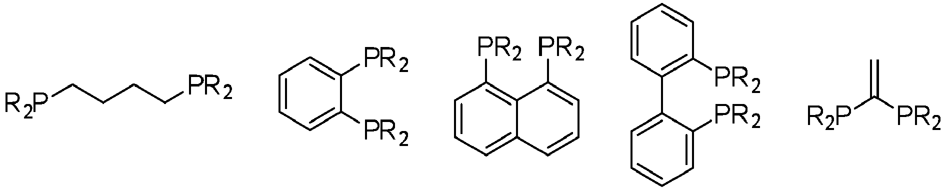

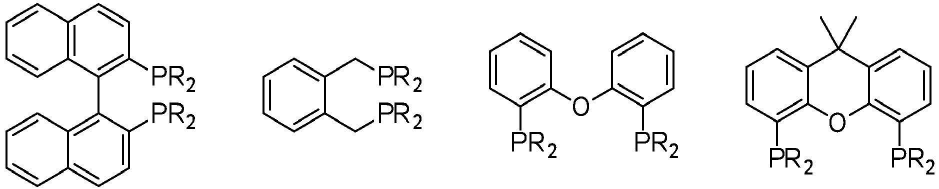

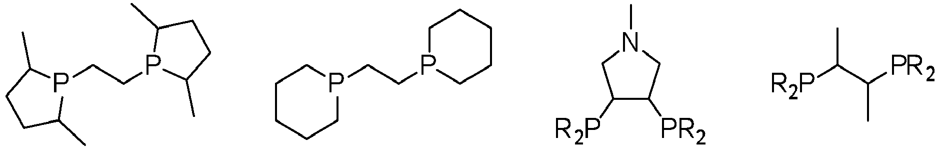

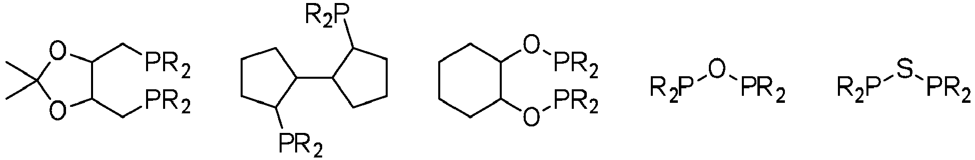

Bei den Substituenten R handelt es sich um einen Alkyl-Rest [CH₃-(CH₂)ₙ-] (n = 0 - 20), der auch verzweigt oder mit Halogenen (F, Cl, Br, I) oder Deuterium substituiert sein kann, oder um einen Aryl-Rest (insbesondere Phenyl), der mit Alkyl-Gruppen, Halogenen (F, Cl, Br, I), oder Deuterium, Silan- (-SiR'₃) oder Ethergruppen -OR' (R' definiert wie R) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), oder Deuterium, Silan- (-SiR"₃) oder Ethergruppen -OR" (R" definiert wie R) substituiert sein können.

### Definition der Funktions-Gruppen FG:

Die Funktions-Gruppen (FG) können entweder einfach oder mehrfach am N∩L Liganden gebunden sein. Es können identische oder unterschiedliche Funktions-Gruppen verwendet werden. Die Funktions-Gruppen können auch symmetrisch oder unsymmetrisch vorhanden sein. Meist ist aus synthetischen Gründen eine Zweifachsubstitution identischer Funktions-Gruppen vorteilhaft.

### Elektronenleiter

Da es sich bei den Elektronenleiter-Materialien ausschließlich um aromatische Verbindungen handelt, ist eine Substitution mithilfe einer der gängigen Kupplungsreaktionen möglich. Als Kupplungsreaktionen kommen z. B. die Suzuki-, Still-, Heck-, Sonogashira-, Kumuda-, Ullmann-, Buchwald-Hartwig-Kupplung sowie deren Varianten zu Einsatz.

Dabei geht man von einem mit Halogenid (Cl, Br, I), insbesondere Br oder I, substituierten N∩L-Ligand oder L-B-L-Ligand aus und setzt es mit dem entsprechenden, mit einer geeigneten Abgangsgruppe substituierten Elektronenleiter-Material um. Vorteilhaft ist die Durchführung einer Suzuki-Kupplung unter Verwendung der entsprechenden Arylboronsäuren und -estern, sowie die Buchwald-Hartwig-Kupplung für die Knüpfung von Aryl-N-Bindungen. Abhängig von den Funktions-Gruppen können auch weitere, gängige Verknüpfungsreaktionen angewandt werden, z. B. über eine Brücke zwischen Funktions-Gruppe FG und N∩L-Ligand. Bei Anwesenheit von -OH Gruppen kommen hier z. B. Veresterungen und Etherbildung in Frage, bei -NH₂ Gruppen Imin- und Amidbildung, bei - COOH Gruppen Esterbildung. Entsprechend muss das Subsitutionsmuster des N∩L angepasst werden (siehe oben unter Punkt "N∩L -Ligand"). Die entsprechenden Verfahren zur Anbringung der Funktions-Gruppen FG sind dem Fachmann bekannt.

Als Elektronentransport-Substituenten können beispielsweise folgende Gruppen verwendet werden (Verknüpfung findet an der mit # gekennzeichneten Stelle statt):

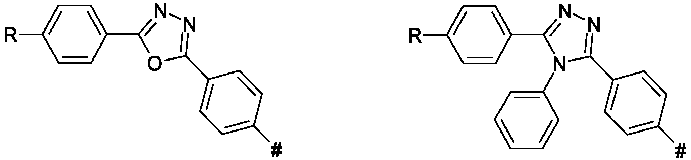

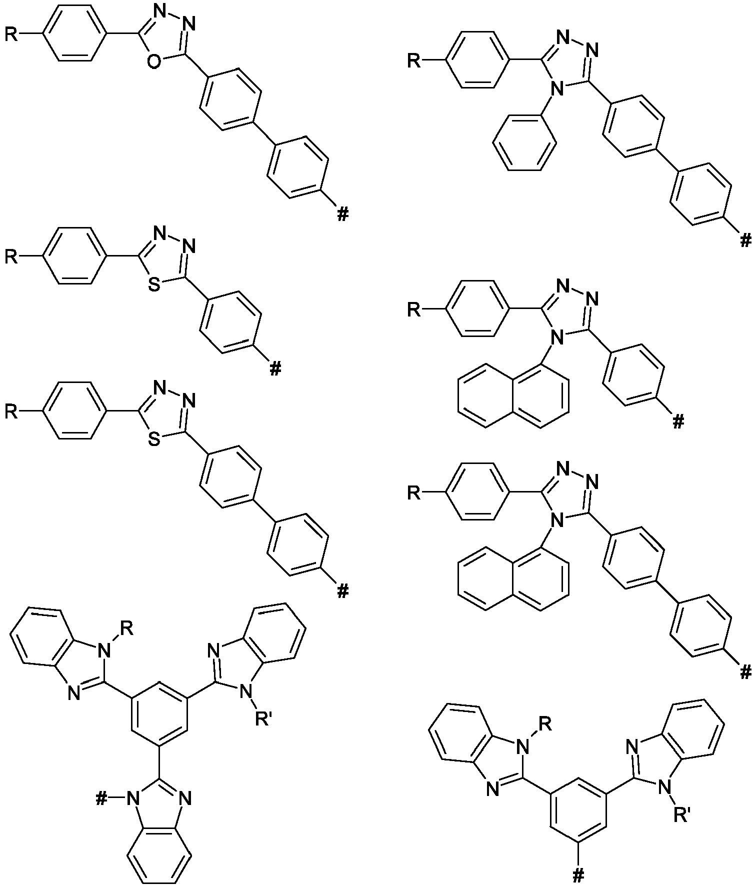

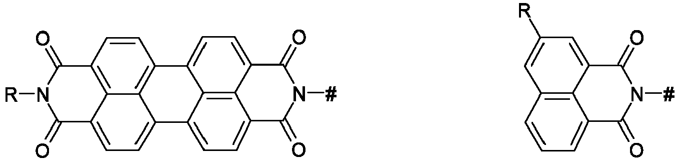

Bei den Substituenten R und R' handelt es sich um einen Alkyl-Rest [CH₃-(CH₂)ₙ-] (n = 0 - 20), der auch verzweigt oder mit Halogenen (F, Cl, Br, I) oder Deuterium substituiert sein kann, oder um einen Aryl-Rest (insbesondere Phenyl), der mit Alkyl-Gruppen, Halogenen (F, Cl, Br, I), oder Deuterium, Silan- (-SiR'"₃) oder Ethergruppen -OR"' (R"' definiert wie R; die hier verwendeten Substituenten entsprechen nicht notwendiger Weise den Substituenten R, R', R" der Formel A) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), oder Deuterium, Silan- (-SiR"₃) oder Ethergruppen -OR" (R" definiert wie R) substituiert sein können.

### Lochleiter

Für den Lochleiter gelten analog die gleichen Aussagen wie für die Elektronenleiter. Auch hier wird die Verknüpfung des Lochleiters an den N∩L -Liganden am einfachsten durch Palladium katalysierte Kupplungsreaktionen verwirklicht; weitere Verknüpfungen, auch über eine Brücke, sind ebenfalls möglich.

Als Lochtransport-Substituenten können beispielsweise folgende Gruppen verwendet werden (Verknüpfung findet an der mit # gekennzeichneten Stelle statt):

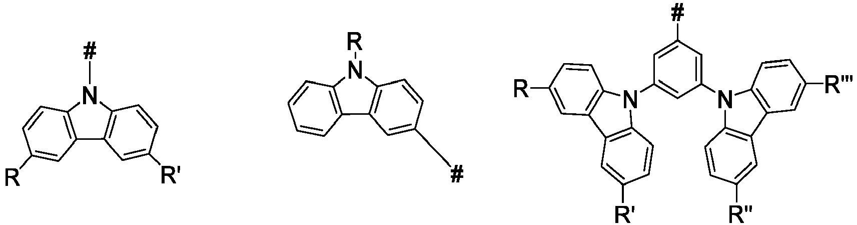

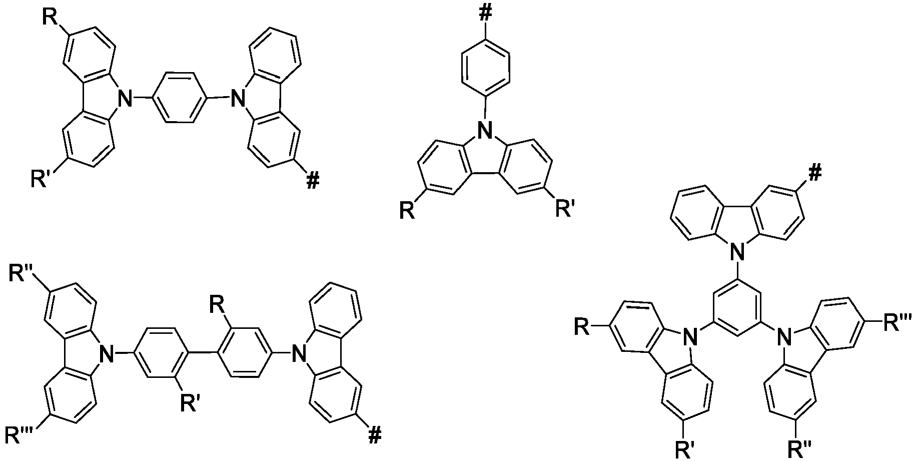

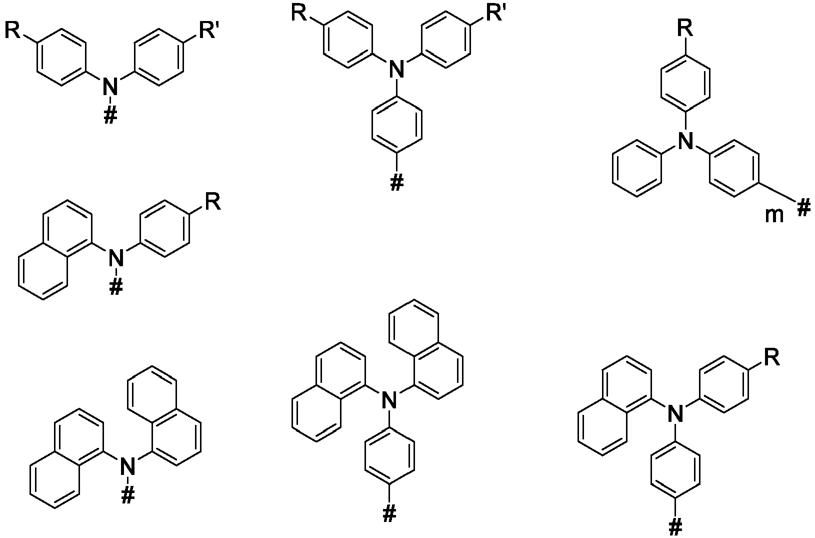

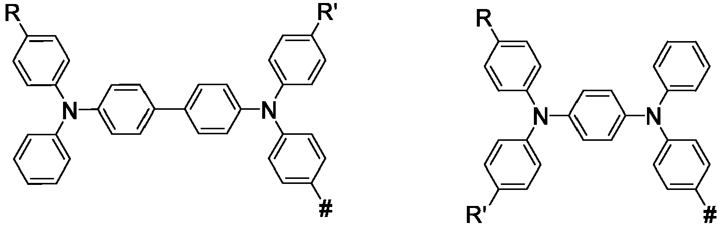

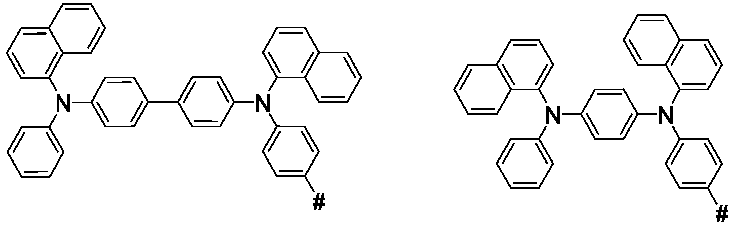

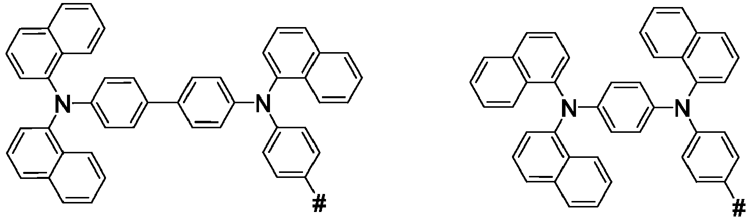

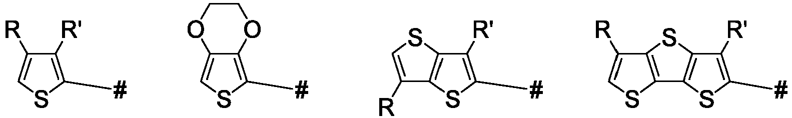

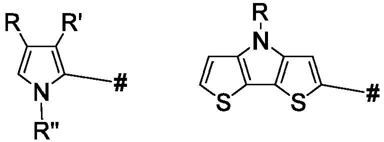

Bei den Substituenten R, R" und R"' handelt es sich um einen Alkyl-Rest [CH₃-(CH₂)ₙ-] (n = 0 - 20), der auch verzweigt oder mit Halogenen (F, Cl, Br, I) oder Deuterium substituiert sein kann, oder um einen Aryl-Rest (insbesondere Phenyl), der mit Alkyl-Gruppen, Halogenen (F, Cl, Br, I), oder Deuterium, Silan- (-SiR"";) oder Ethergruppen -OR"" (R"" definiert wie R; die hier verwendeten Substituenten entsprechen nicht notwendiger Weise den Substituenten R, R', R" der Formel A) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), oder Deuterium, Silan- (-SiR"₃) oder Ethergruppen -OR" (R" definiert wie R) substituiert sein können.

### Löslichkeit

Bei einer Herstellung von opto-elektronischen Bauteilen mittels nass-chemischer Prozesse ist es vorteilhaft, die Löslichkeit gezielt einzustellen. Hierdurch kann das Auf- bzw. Anlösen einer bereits aufgebrachten Schicht vermieden werden. Durch das Einbringen spezieller Substituenten können die Löslichkeitseigenschaften stark beeinflusst werden. Dadurch ist es möglich, orthogonale Lösungsmittel zu verwenden, die jeweils nur die Substanzen des aktuellen Verarbeitungsschrittes lösen, aber nicht die Substanzen der darunter liegenden Schicht(en):

### Löslichkeit in unpolaren Medien

Unpolare Funktions-Gruppen FG erhöhen die Löslichkeit in unpolaren Lösungsmitteln und erniedrigen die Löslichkeit in polaren Lösungsmitteln. Unpolare Gruppen sind z. B. Alkylgruppen [CH₃-(CH₂)ₙ-] (n = 1 - 30), auch verzweigte, substituierte Alkylgruppen, z. B. mit Halogenen. Hierbei sind besonders hervorzuheben: teil- oder perfluorierte Alkylgruppen sowie perfluorierte Oligo- und Polyether, z. B. [-(CF₂)₂-O]ₙ- und (-CF₂-O)ₙ- (n = 2 - 500). Weitere unpolare Gruppen sind: Ether -OR, Thioether -SR, unterschiedlich substituierte Silane R₃Si- (R = Alkyl oder Aryl), Siloxane R₃Si-O-, Oligosiloxane R'(-R₂Si-O)ₙ- (R' = R, n = 2 - 20), Polysiloxane R'(-R₂Si-O)ₙ- (n > 20); Oligo/polyphosphazene R'(-R₂P=N-)ₙ- (n = 1 - 200).

### Löslichkeit in polaren Medien

Polare Funktionsgruppen erhöhen die Löslichkeit in polaren Medien. Diese können sein:
- Alkohol-Gruppen: -OH
- Thioalkohole -SH
- Carbonsäure-, Phosphonsäure-, Sulfonsäure-Reste sowie deren Salze und Ester (R = H, Alkyl, Aryl, Halogen; Kationen: Alkalimetalle, Ammonium-Salze):
   -COOH, -P(O)(OH)₂, -P(S)(OH)₂, -S(O)(OH)₂, -COOR, -P(O)(OR)₂, -P(S)(OR)₂, -S(O)(OR)₂, -CONHR, -P(O)(NR₂)₂, -P(S)(NR₂)₂, -S(O)(NR₂)₂
- Sulfoxide: -S(O)R, -S(O)₂R
- Carbonylgruppen: -C(O)R
- Amine: -NH₂, -NR₂, -N(CH₂CH₂OH)₂,
- Hydroxylamine =NOR
- Oligoester, -O(CH₂O-)ₙ, -O(CH₂CH₂O-)ₙ (n = 2 - 200)
- Positiv geladene Substituenten: z. B. Ammonium-Salze -N⁺R₃X⁻, Phosphonium-Salze -P⁺R₃X⁻
- Negativ geladene Substituenten, z. B. Borate -(BR₃)⁻, Aluminate -(AlR₃)⁻ (als Anion kann ein Alkalimetal oder Ammoniumion fungieren).

Um die Anwesenheit frei beweglicher Ionen zu vermeiden, können auch positiv und negativ geladene Substituenten in einer Funktions-Gruppe FG vereinigt werden.

Die Kupfer(I)komplexe der Formel A können erfindungsgemäß als Emitter in einer Emitterschicht eines Licht-emittierenden optoelektronischen Bauelements eingesetzt werden. Die optoelektronischen Bauelemente sind bevorzugt die folgenden: Organischen Lichtemittierenden Bauteilen (OLEDs), Licht-emittierenden elektrochemischen Zellen, OLED-Sensoren (insbesondere in nicht hermetisch nach außen abgeschirmten Gas- und Dampf-Sensoren), organischen Solarzellen, Organische Feldeffekttransistoren, organische Laser und Down-Konversions-Elemente.

Die Kupfer(I)komplexe der Formel A können erfindungsgemäß auch als Absorber-Materialien in einer Absorberschicht eines optoelektronischen Bauelements eingesetzt werden.

Unter der Bezeichnung "optoelektronische Bauelemente" werden insbesondere verstanden:
- Organische Licht-emittierende Bauteile (organic light emitting diodes, OLEDs)
- Licht-emittierende elektrochemische Zellen (light emitting electrochemical cells, LECs, LEECs),
- OLED-Sensoren, insbesondere in nicht hermetisch nach außen abgeschirmten Gas- und Dampf-Sensoren,
- organische Solarzellen (organic solar cells, OSCs, organic photovoltaics, OPVs),
- Organische Feldeffekttransistoren und
- Organische Laser.

Der Anteil des Kupfer(I)komplexes in der Emitter- oder Absorber-Schicht in einem derartigen optoelektronischen Bauelement beträgt in einer Ausführungsform der Erfindung 100 %. In einer alternativen Ausführungsform beträgt der Anteil des Kupfer(I)komplexes in der Emitter- oder Absorber-Schicht 1 % bis 99 %.

Vorteilhafter Weise beträgt die Konzentration des Kupfer(I)komplexes als Emitter in optischen Licht emittierenden Bauelementen, insbesondere in OLEDs, zwischen 4 % und 50 %.

Gegenstand der vorliegenden Erfindung sind auch optoelektronische Bauelemente, die einen hier beschriebenen Kupfer(I)komplex aufweisen. Dabei kann das optoelektronische Bauelement ausgeformt sein als ein organisch lichtemittierendes Bauelement, eine organische Diode, eine organische Solarzelle, ein organischer Transistor, als eine organische Licht-emittierende Diode, eine Licht-emittierende elektrochemische Zelle, ein organischer Feldeffekttransistor und als ein organischer Laser.

Demgemäß betrifft die Erfindung in einem weiteren Aspekt ein Verfahren zur Herstellung einer opto-elektronischen Vorrichtung, insbesondere wobei die Herstellung nass-chemisch erfolgt und das Verfahren die folgenden Schritte aufweist:
Aufbringung eines in einem ersten Lösungsmittel gelösten ersten Emitterkomplexes auf einen Träger, und Aufbringung eines in einem zweiten Lösungsmittel gelösten zweiten Emitterkomplexes auf den Träger;
wobei der erste Emitterkomplexes nicht in dem zweiten Lösungsmittel löslich ist und der zweite Emitterkomplexes nicht in dem ersten Lösungsmittel löslich ist; und wobei der erste Emitterkomplex und/oder der zweite Emitterkomplex ein erfindungsgemäßer Kupfer(I)komplex ist. Das Verfahren kann weiterhin den folgenden Schritt aufweisen: Aufbringung eines in dem ersten Lösungsmittel oder in einem dritten Lösungsmittel gelösten dritten Emitterkomplexes auf den Träger, wobei der dritte Kupfer(I)komplex ein erfindungsgemäßer Kupfer(I)komplex ist. Erstes und zweites Lösungsmittel sind dabei nicht identisch.

In einer bevorzugten Ausführungsform ist die opto-elektronische Vorrichtung eine Weißlicht-OLED, wobei der erste Emitterkomplexe ein Rotlichtemitter ist, der zweite Emitterkomplex ein Grünlichtemitter ist und der dritte Emitterkomplexe ein Blaulichtemitter ist.

Ein weiterer Aspekt der Erfindung betrifft ein Verfahren zur Veränderung der Emissions- und/oder Absorptionseigenschaften eines elektronischen Bauelements. Dabei wird ein erfindungsgemäßer Kupfer(I)komplexe in ein Matrixmaterial zur Leitung von Elektronen oder Löchern in ein optoelektronisches Bauelement eingebracht.

Ein weiterer Aspekt der Erfindung betrifft eine Verwendung eines erfindungsgemäßen Kupfer(I)komplexes, insbesondere in einem optoelektronischen Bauelement, zur Umwandlung von UV-Strahlung oder von blauem Licht in sichtbares Licht, insbesondere in grünes, gelbes oder rotes Licht (Down-Konversion).

### Figuren

**Figur 1****:** Prinzipieller Aufbau eines OLEDs. Die Abbildung ist nicht maßstabsgerecht gezeichnet.

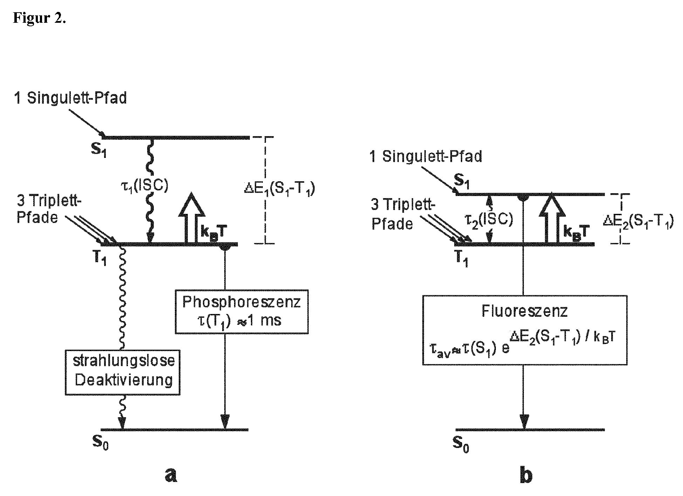

**Figur 2****:** Erläuterungen des Elektro-Lumineszenz-Verhaltens **a** für ÜbergangsmetallKomplexe mit kleiner oder sich nur in geringem Maße auswirkender Spin-Bahn-Kopplung (z. B. Metall-Komplexe der ersten Periode der Übergangsmetalle) und **b** für erfindungsgemäß selektierte Cu(I)-Komplexe. Der in **a** für τ(T₁) angegebene Wert repräsentiert ein Beispiel.
**Figuren 3 bis 5****:** ORTEP-Bilder verschiedener Cu(N∩L)(L-B-L)-Komplexe.
**Figuren 6 bis 14****:** Emissionsspektren verschiedener Cu(N∩L)(L-B-L)-Komplexe.

### Beispiele

### Synthese der Cu(I)-Komplexe:

Unter Verwendung der oben dargestellten Liganden werden die entsprechenden neutralen Cu(N∩L)(L-B-L)-Komplexe hergestellt:

### Beispiel 1

Unter Stickstoff wurden der entsprechende N∩L-Ligand (1.00 mmol, 1.00 Äquiv.), [Cu(CH₃CN)₄]PF₆ **(10)** (1.00 mmol, 1.00 Äquiv.) und der L-B-L-Ligand (1.00 mmol, 1.00 Äquiv.) in 10 mL Lösungsmittelgemisch aus Dichlormethan:Ethanol = 3:1 unter Stickstoff gelöst und 4 h gerührt. Der Komplex wurde durch Ausfällen in Diethylether gereinigt, abfiltriert, mit Diethylether gewaschen und getrocknet.

Unter Stickstoff wurden der oben erhaltene Komplex (0.05 mmol, 1.00 Äquiv.) und KOH (7.75 mmol, 15.0 Äquiv.) in 5 mL Methanol unter Stickstoff gelöst und 6 h gerührt. Anschließend wurde das Lösungsmittel im Vakuum entfernt, der Rückstand mit DCM extrahiert und filtriert. Nach Entfernen des Lösungsmittels wurde der Komplex als weißes Pulver erhalten.

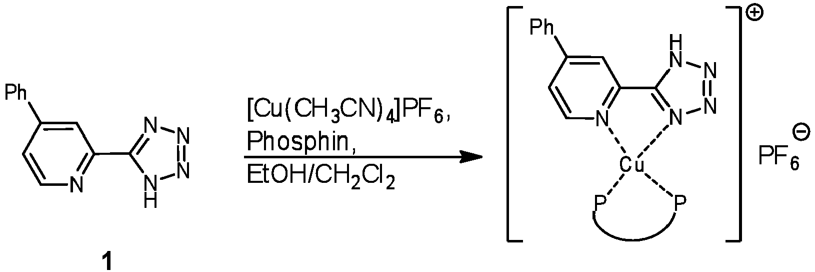

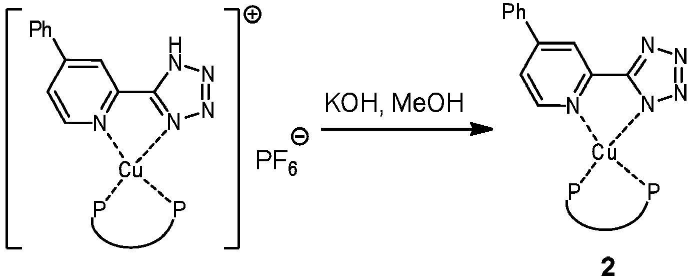

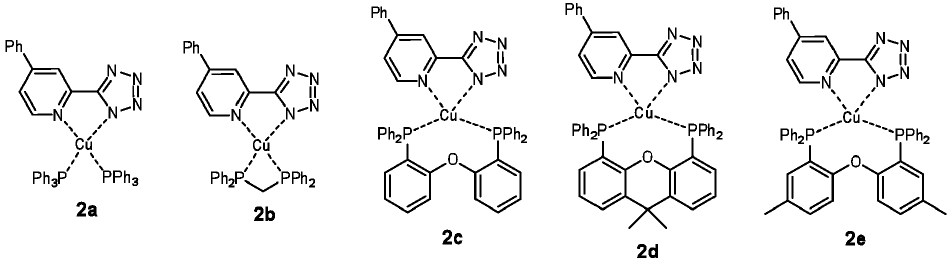

### 2c: L-B-L = Bis(diphenylphosphin)diphenylether:

### Charakterisierung:

| | |
|---|---|
| Elementaranalyse: C₄₈H₃₆CuN₅OP₂ (823.17): | ber. C 69.94, H 4.40, N 8.50; |
| | gef. C 69.41, H 4.47, N 8.00. |

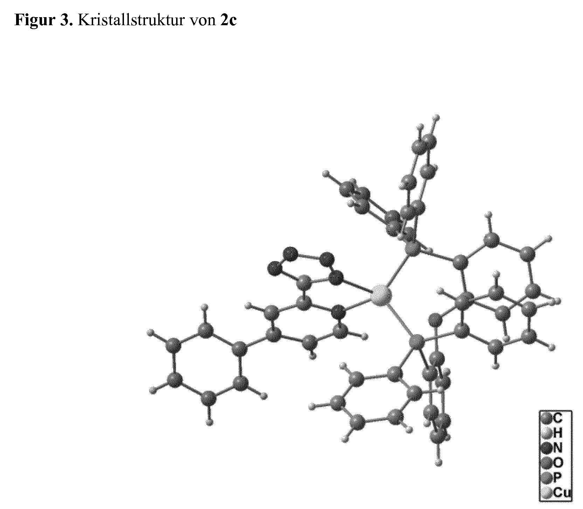

MS (FAB), *m*/*z* (%): 1423 (3) [LCu₂(P^P)₂], 1139 (1) [Cu(P^P)₂], 888 (1) [LCu₂P^P], 860 (6) [LCu₂P^P-N₂], 823 (7) [LCuP^P], 767 (5) [LCuP^P-N₄] , 692 (1) [LCuP^P-N₄-Ph], 601 (100) [CuP^P], L :Tetrazol- Ligand, P^P : Phosphin-Ligand. Die Kristallstruktur von **2c** ist in Fig. 3 dargestellt.

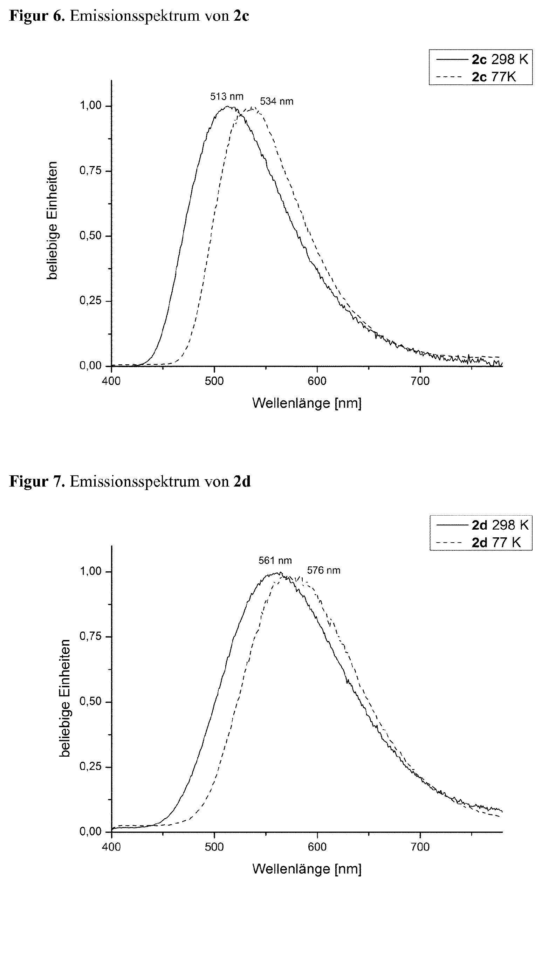

Das Emissionsspektrum von **2c** bei 298 K ist in Fig. 6 gezeigt.
Das Emissionsspektrum von **2c** bei 77 K ist in Fig. 6 gezeigt.
Die Emissionsquantenausbeute von **2c** beträgt 38 % (gemessen mit Hamamatsu C9920-02G).
Die Emissionslebensdauer von **2c** beträgt 2.8 µs (Horiba Fluoromax 4 mit TCSPC).
Der ΔE(S₁-T₁)-Wert von **2c** beträgt 766 cm⁻¹ (ermittelt durch Messung der Temperaturabhängigkeit der Fluoreszenz- und der Phosphoreszenz-Intensität)

### 2d: L-B-L = (9,9-Dimethyl-9H-xanthen-4,5-diyl)bis(diphenylphosphin):

### Charakterisierung:

| | |
|---|---|
| Elementaranalyse: C₅₁H₄₀CuN₅OP₂ (863.20): | ber. C 70.86, H 4.66, N 8.10; |
| | gef. C 69.59, H 4.77, N 7.61. |

MS (FAB), *m*/*z* (%): 1790 (1) [L₂Cu₃(P^P)₂], 1505 (18) [LCu₂(P^P)₂], 1220 (1) [Cu₂(P^P)₂], 957 (2), 926 (2) [LCu₂P^P], 863 (2) [LCuP^P], 808 (7) [LCuP^P-N₄], 730 (2) [LCuP^P-N₄-Ph], 641 (100) [CuP^P], L :Tetrazol- Ligand, P^P : Phosphin-Ligand.

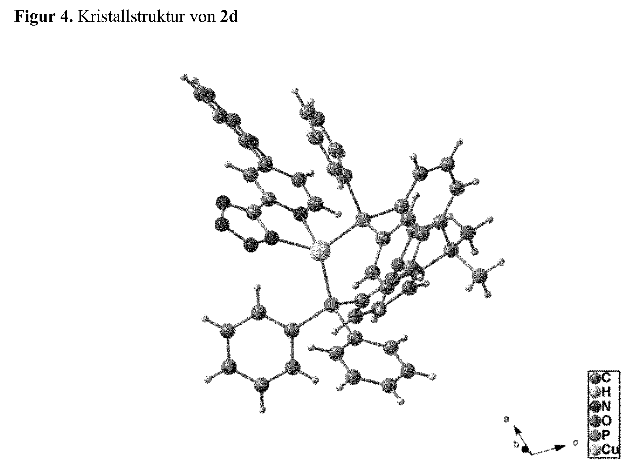

Die Kristallstruktur von **2d** ist in Fig. 4 dargestellt.
Das Emissionsspektrum von **2d** bei 298 K ist in Fig. 7 gezeigt.
Das Emissionsspektrum von **2d** bei 77 K ist in Fig. 7 gezeigt.
Die Emissionsquantenausbeute von **2d** beträgt 80 % (gemessen mit Hamamatsu C9920-02G).
Die Emissionslebensdauer von **2d** beträgt 0.8 µs (Horiba Fluoromax 4 mit TCSPC).
Der ΔE(S₁-T₁)-Wert von **2d** beträgt 464 cm⁻¹ (ermittelt durch Messung der Temperaturabhängigkeit der Fluoreszenz- und der Phosphoreszenz-Intensität)

### 2e: L-B-L = (Oxybis(3-methyl-6,1-phenylen))bis(diphenylphosphin):

### Charakterisierung:

| | |
|---|---|
| Elementaranalyse: C₅₀H₄₀CuN₅OP₂ (851.20): | ber. C 70.22, H 5.10, N 7.87 (+ 0.5x Et₂O.; |
| | gef. C 69.31, H 4.96, N 7.07. |

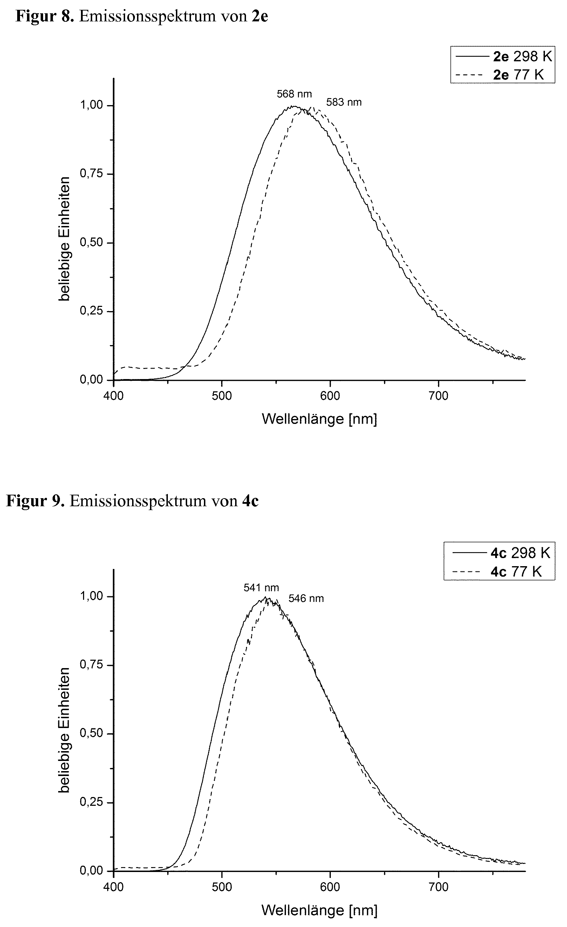

Das Emissionsspektrum von **2e** bei 298 K ist in Fig. 8 gezeigt.
Das Emissionsspektrum von **2e** bei 77 K ist in Fig. 8 gezeigt.
Die Emissionsquantenausbeute von **2e** beträgt 92 % (gemessen mit Hamamatsu C9920-02G).
Die Emissionslebensdauer von **2e** beträgt 1.1 µs (Horiba Fluoromax 4 mit TCSPC).
Der ΔE(S₁-T₁)-Wert von **2e** beträgt 453 cm⁻¹ (ermittelt durch Messung der Temperaturabhängigkeit der Fluoreszenz- und der Phosphoreszenz-Intensität)

### Beispiel 2

Unter Stickstoffatmosphäre wurde der N∩L-Ligand (1.00 mmol, 1.00 Äquiv.) in 10 mL Dichlormethan gelöst, mit einer äquimolaren Menge an Base versetzt und eine Stunde rühren gelassen. Dann wurde eine äquimolare Menge Cu(CH₃CN)₄]BF₄ zugegeben, eine Stunde rühren gelassen, mit einer äquimolaren Menge des entsprechenden L-B-L-Liganden versetzt und über Nacht rühren gelassen. Der Komplex wurde durch Ausfällen in Diethylether gereinigt, abfiltriert, mit Diethylether gewaschen und getrocknet.

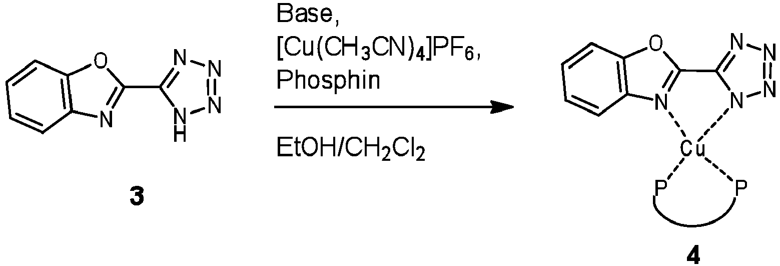

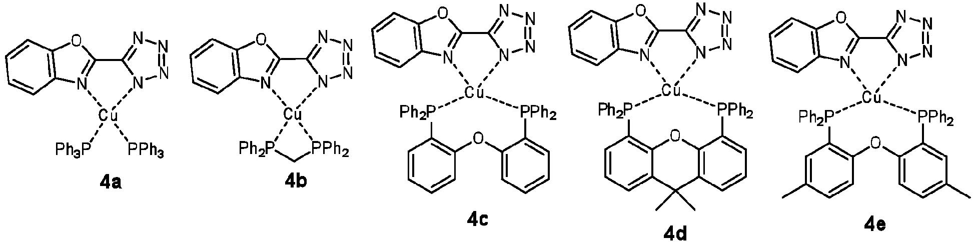

### 4a: L-B-L = 2x PPh₃:

### Charakterisierung:

Die Emissionslebensdauer von **4a** beträgt 0.8 µs (Horiba Fluoromax 4 mit TCSPC).

### 4c: L-B-L = Bis(diphenylphosphin)diphenylether:

### Charakterisierung:

Das Emissionsspektrum von **4c** bei 298 K ist in Fig. 9 gezeigt.
Das Emissionsspektrum von **4c** bei 77 K ist in Fig. 9 gezeigt.
Die Emissionsquantenausbeute von **4c** beträgt 65 % (gemessen mit Hamamatsu C9920-02G).
Die Emissionslebensdauer von **4c** beträgt 1.0 µs (Horiba Fluoromax 4 mit TCSPC).
Der ΔE(S₁-T₁)-Wert von **4c** beträgt 169 cm⁻¹ (ermittelt durch Messung der Temperaturabhängigkeit der Fluoreszenz- und der Phosphoreszenz-Intensität)

### 4e: L-B-L = (Oxybis(3-methyl-6,l-phenylen))bis(diphenylphosphin):

### Charakterisierung:

MS (FAB), *m*/*z* (%): 1691 (1) [L₂Cu₃(P^P)₂], 1534 (1), 1446 (3) [LCu₂(P^P)₂], 1284 (2) [LCu(P^P)₂-N₄-(CH₃)₃], 853 (6) [LCuP^P-N₂], 816 (2) [LCuP^P], 759 (4) [LCuP^P-N₄], 629 (100) [CuP^P], L : Tetrazol-Ligand, P^P : Phosphin-Ligand.

### Beispiel 3

Die Synthese erfolgte analog der in Beispiel 2 genannten.

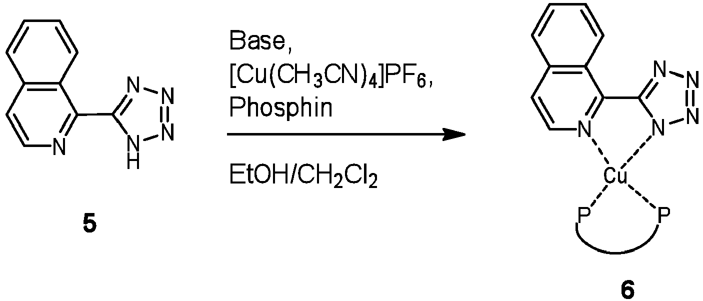

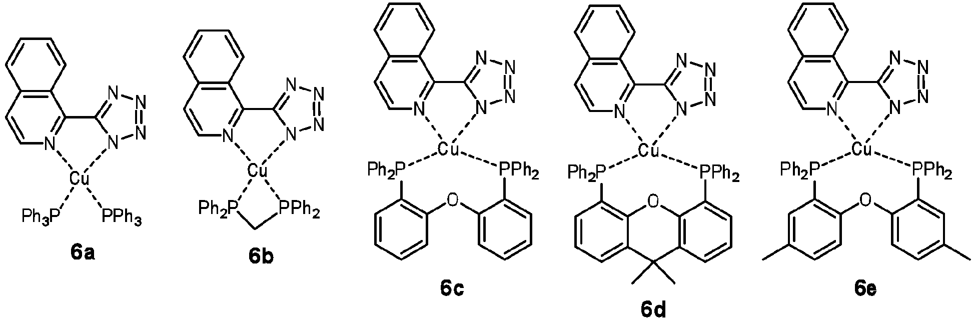

### 6c: L-B-L = Bis(diphenylphosphin)diphenylether:

### Charakterisierung:

MS (FAB), *m*/*z* (%): 2195 (1) [L₂Cu₃(P^P)₃], 1917 (1) [L₃Cu₄(P^P)₂], 1660 (1) [L₂Cu₃(P^P)₂], 1400 (10) [LCu₂(P^P)₂], 1140 (2) [Cu(P^P)₂], 860 (5) [LCu₂(P^P)], 798 (4) [LCuP^P], 741 (6) [LCuP^P-N₄], 602 (100) [CuP^P].

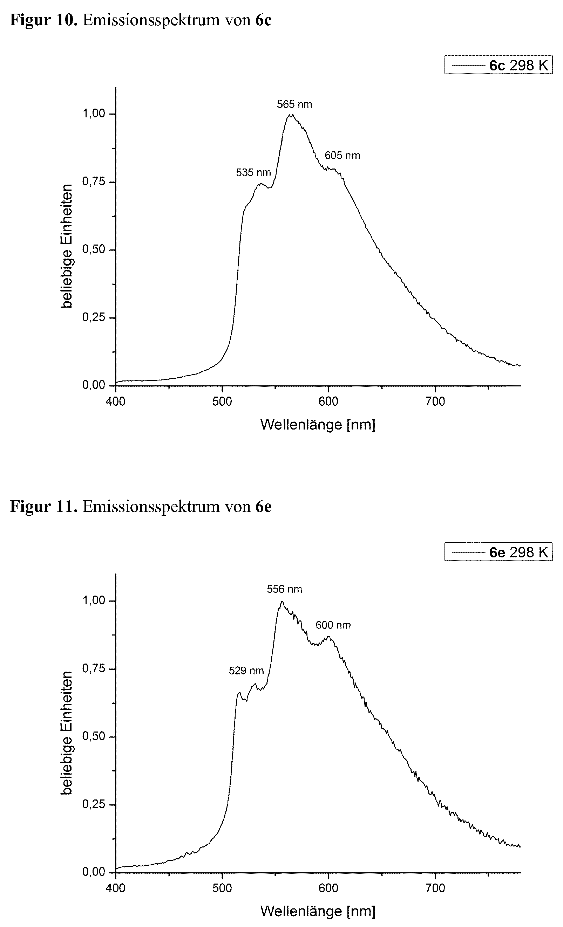

Das Emissionsspektrum von **6c** bei 298 K ist in Fig. 10 gezeigt.

Die Emissionsquantenausbeute von **6c** beträgt 20 % (gemessen mit Hamamatsu C9920-02G).

Die Emissionslebensdauer von **6c** beträgt 0.7 µs (Horiba Fluoromax 4 mit TCSPC).

### 6e: L-B-L = (Oxybis(3-methyl-6,1-phenylen))bis(diphenylphosphin):

### Charakterisierung:

MS (FAB), *m*/*z* (%): 2278 (1) [L₄Cu₆(P^P)₂-CH₃], 1713 (2) [L₂Cu₃(P^P)₂], 1455 (12) [LCu₂(P^P)₂], 1196 (1) [Cu(P^P)₂], 889 (7) [LCu₂(P^P)], 825 (2) [LCuP^P], 769 (3) [LCuP^P-N₄], 739 (2) [LCuP^P-N₄-(CH₃)₂], 692 (2) [Cu₂P^P], 629 (100) [CuP^P], L : Tetrazol-Ligand, P^P : Phosphin-Ligand.

Das Emissionsspektrum von **6e** bei 298 K ist in Fig. 11 gezeigt.

### Beispiel 4

Die Synthese erfolgte analog der in Beispiel 1 genannten.

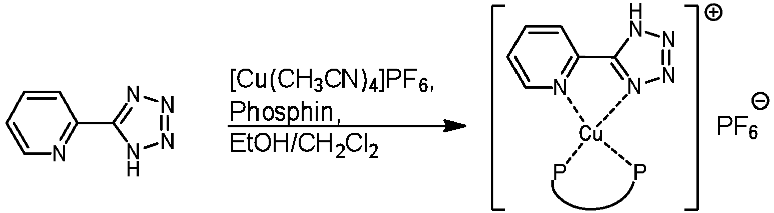

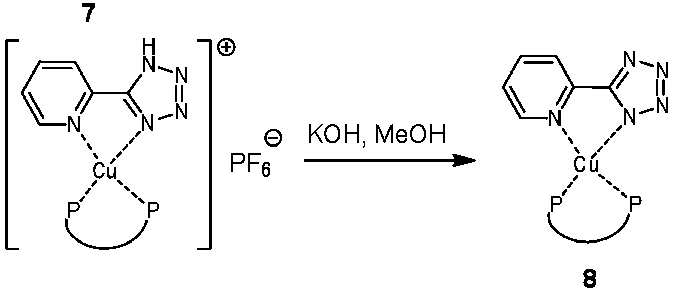

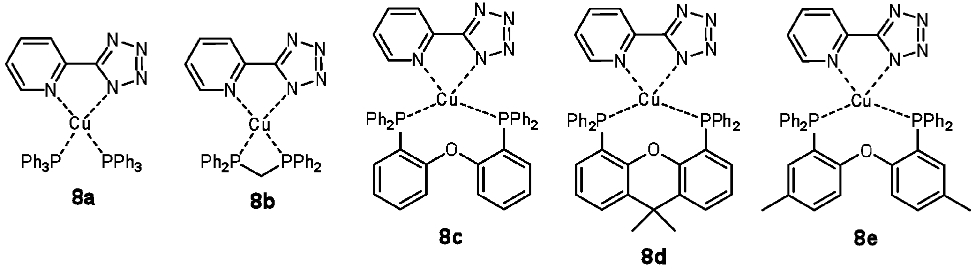

### 8a: L-B-L = 2x PPh3:

### Charakterisierung:

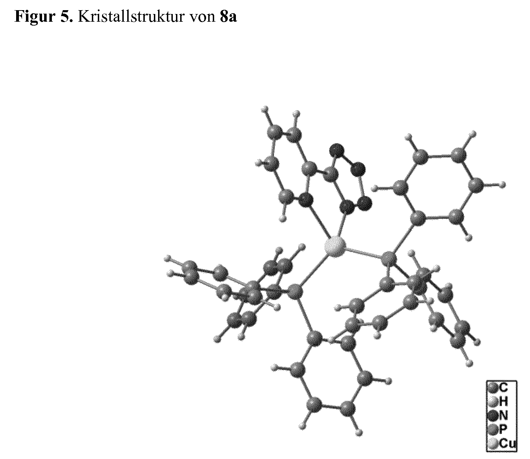

Die Kristallstruktur von **8a** ist in Fig. 5 dargestellt.

Die Emissionsquantenausbeute von **8a** beträgt 40 % (gemessen mit Hamamatsu C9920-02G).

### 8c: L-B-L = Bis(diphenylphosphin)diphenylether:

### Charakterisierung:

| | |
|---|---|
| Elementaranalyse: C₄₂H₃₂CuN₅OP₂ (747.14): | ber. C 67.42, H 4.31, N 9.36; |
| | gef. C 66.84, H 4.40, N 9.16 |

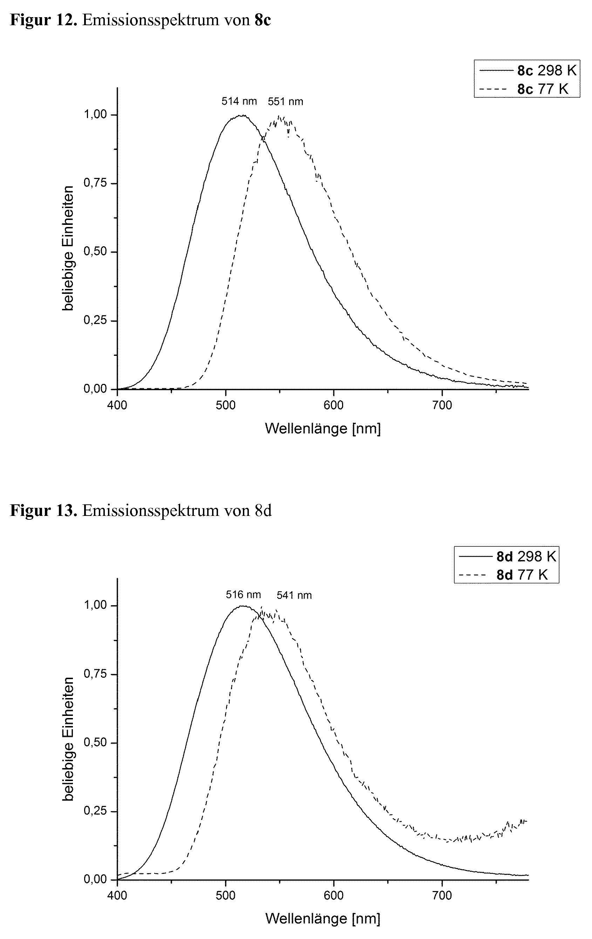

Das Emissionsspektrum von **8c** bei 298 K ist in Fig. 12 gezeigt.
Das Emissionsspektrum von **8c** bei 77 K ist in Fig. 12 gezeigt.
Die Emissionsquantenausbeute von **8c** beträgt 62 % (gemessen mit Hamamatsu C9920-02G).
Die Emissionslebensdauer von **8c** beträgt 0.7 µs (Horiba Fluoromax 4 mit TCSPC).
Der ΔE(S₁-T₁)-Wert von **8c** beträgt 1306 cm⁻¹ (ermittelt durch Messung der Temperaturabhängigkeit der Fluoreszenz- und der Phosphoreszenz-Intensität)

### 8d: L-B-L = (9,9-Dimethyl-9H-xanthen-4,5-diyl)bis(diphenylphosphin):

### Charakterisierung:

| | |
|---|---|
| Elementaranalyse: C₄₅H₃₆CuN₅OP₂ (787.17): | ber. C 63.27, H 4.39, N 8.02 (+ 1x CH₂Cl₂); |
| | gef. C 64.83, H 4.53, N 7.95 |

MS (FAB), *m*/*z* (%): 1640 (1) [L₂Cu₃(P^P)₂], 1429 (16) [LCu₂(P^P)₂], 958 (1), 850 (1) [LCu₂P^P], 787 (6) [LCuP^P], 730 (6), 641 (100) [CuP^P], L: Tetrazol-Ligand, P^P: Phosphin-Ligand.

Das Emissionsspektrum von **8d** bei 298 K ist in Fig. 13 gezeigt.
Das Emissionsspektrum von **8d** bei 77 K ist in Fig. 13 gezeigt.
Die Emissionsquantenausbeute von **8d** beträgt 76 % (gemessen mit Hamamatsu C9920-02G).
Die Emissionslebensdauer von **8d** beträgt 0.9 µs (Horiba Fluoromax 4 mit TCSPC).
Der ΔE(S₁-T₁)-Wert von **8d** beträgt 896 cm⁻¹ (ermittelt durch Messung der Temperaturabhängigkeit der Fluoreszenz- und der Phosphoreszenz-Intensität)

### 8e: L-B-L = (Oxybis(3-methyl-6,l-phenylen))bis(diphenylphosphin):

### Charakterisierung:

| | |
|---|---|
| Elementaranalyse: C₄₄H₃₆CuN₅OP₂ (775.17): | ber. C 67.93, H 5.08, N 8.61 (+ 0.5x Et₂O); |
| | gef. C 67.95, H 4.97, N 8.36 |

MS (FAB), *m*/*z* (%): 1615 (1) [L₂Cu₃(P^P)₂], 1405 (12) [LCu₂(P^P)₂], 1196 (1) [L₃Cu₃P^P], 778 (6) [LCuP^P], 719 (6) [LCuP^P-N₄], 629 (100) [CuP^P], L: Tetrazol-Ligand, P^P: Phosphin-Ligand.

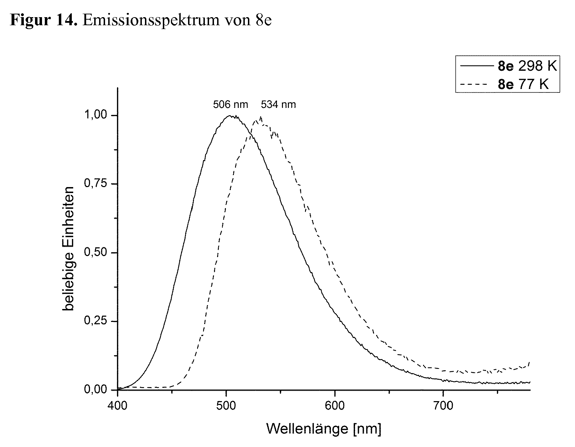

Das Emissionsspektrum von **8e** bei 298 K ist in Fig. 14 gezeigt.
Das Emissionsspektrum von **8e** bei 77 K ist in Fig. 14 gezeigt.
Die Emissionsquantenausbeute von **8e** beträgt 92 % (gemessen mit Hamamatsu C9920-02G).
Die Emissionslebensdauer von **8e** beträgt 0.7 µs (Horiba Fluoromax 4 mit TCSPC).
Der ΔE(S₁-T₁)-Wert von **8e** beträgt 1036 cm⁻¹ (ermittelt durch Messung der Temperaturabhängigkeit der Fluoreszenz- und der Phosphoreszenz-Intensität)

### Beispiel 5

Die Synthese erfolgte analog der in Beispiel 1 genannten.

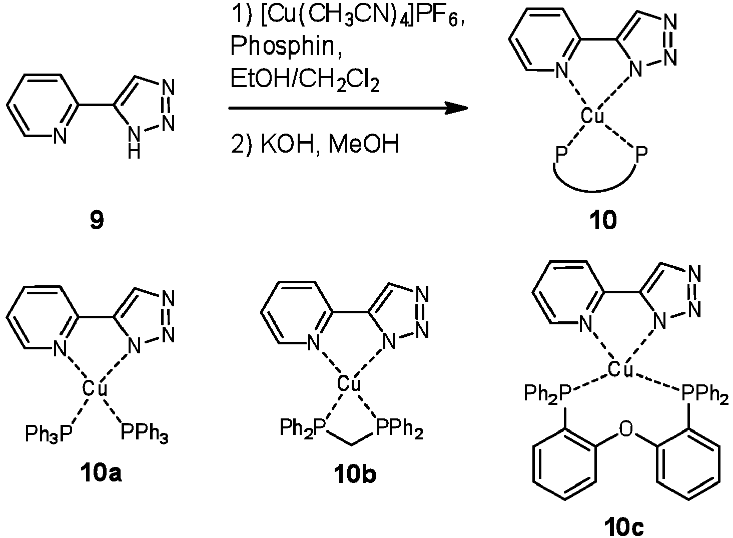

### Beispiel 6

Die Synthese erfolgte analog der in Beispiel 2 genannten.

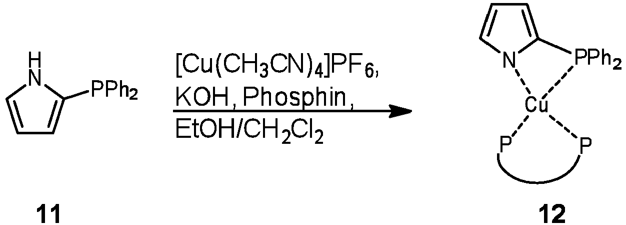

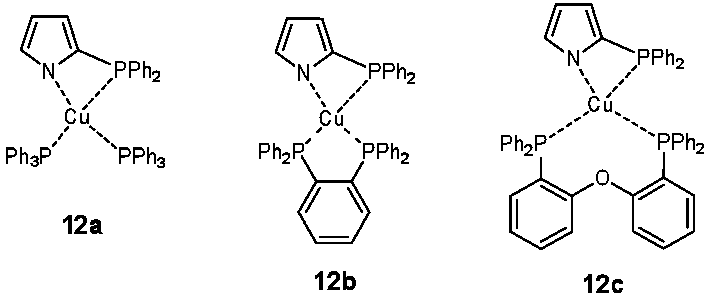

### Beispiel 7

Die Synthese erfolgte analog der in Beispiel 1 genannten.

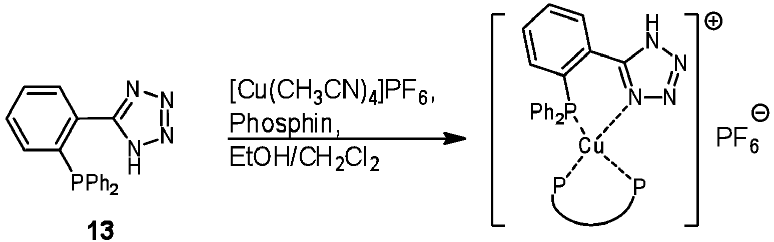

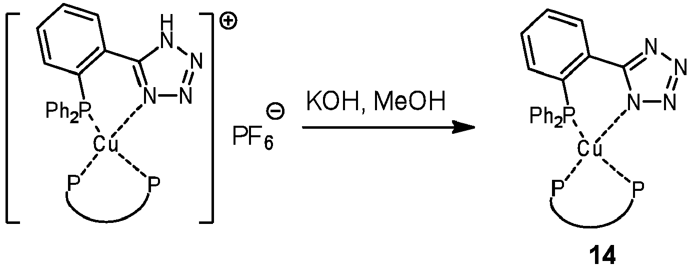

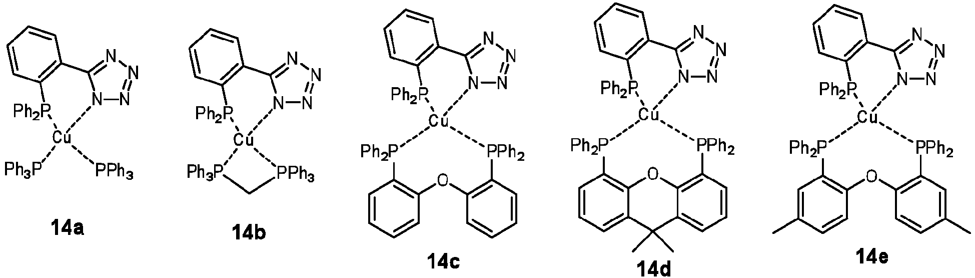

## Patentansprüche

1. Neutraler einkerniger Kupfer(I)komplex zur Emission von Licht aufweisend eine Struktur gemäß Formel A 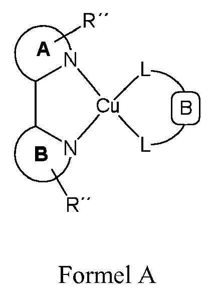 wobei 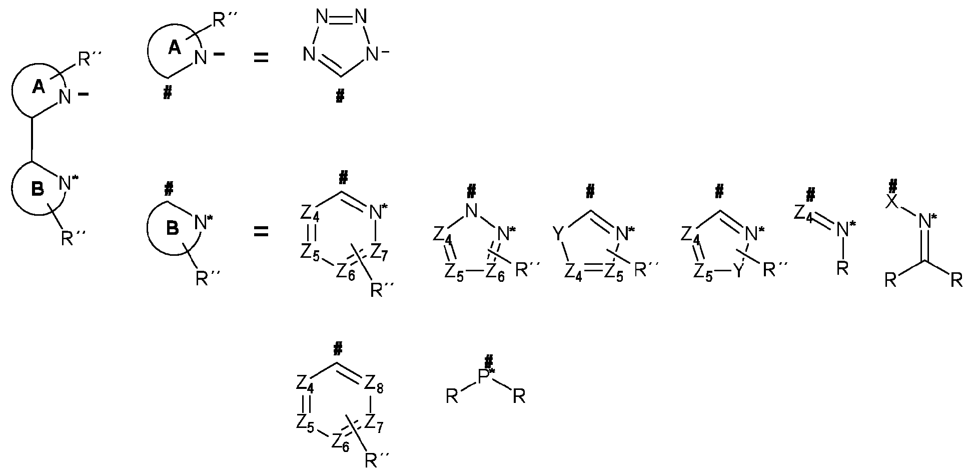 wobei gilt:
• M ist Cu(I);
• L-B-L: ein neutraler, zweizähniger Ligand, bevorzugt ein Phosphanyl- oder Arsanyl-Rest E*(R1)(R2), mit E = P oder As; R1, R2 können jeweils unabhängig voneinander Wasserstoff, Halogen oder Deuterium sein oder Substituenten, die über Sauerstoff- (-OR"'), Stickstoff- (-NR"'₂) oder Siliziumatome (-SiR'"₃) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen, der über eine Brücke B mit einem weiteren Rest L verbunden ist und damit einen zweizähnigen Liganden bildet, wobei die Brücke B eine Alkylen- oder Arylen-Gruppe oder eine Kombination beider, oder -O-, -NR"'- oder -SiR'"2- ist, wobei die Gruppen R1-R2 optional anellierte Ringsysteme bilden;
• Z4-Z7: besteht aus N oder dem Fragment CR,
mit R = organischer Rest, der ausgewählt ist aus der Gruppe bestehend aus: Wasserstoff, Halogen oder Deuterium oder Gruppen, die über Sauerstoff- (-OR''), Stickstoff- (-NR"'₂), Silizium- (-SiR"'₃) oder Phosphoratome (-PR"'₂) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen;
• X ist entweder CR"'₂ oder NR"';
• Y ist entweder O, S oder NR"';
• Z8 besteht aus dem Fragment CR',
mit R' = OR"', NR"'₂ oder PR'"₂, wobei die Bindung zum Cu-Atom dann über diese Gruppen erfolgt;
• R" ist ein sterisch anspruchsvoller Substituent, bevorzugt in ortho-Position zur Koordinationsstelle, der eine Geometrieveränderung in Richtung einer Planarisierung des Komplexes im angeregten Zustand verhindert, bevorzugt ein Alkylrest -(CH₂)ₙ-CH₃ (n = 0 - 20) (auch verzweigt), ein Arylrest mit 6 - 20 Kohlenstoffatomen (z. B. - Ph), Alkoxyrest -O-(CH₂)ₙ-CH₃ (n = 0 - 20), ein Aryloxyrest (z. B. -OPh) oder ein Silanrest (z. B -SiMe₃), wobei die Alkyl- und Arylreste auch substituiert sein können (z. B. mit Halogenen, Deuterium, Alkoxy- oder Silan-Gruppen) und optional zu annelierten Ringsystemen führen,
wobei Formel A keinen, einen oder zwei Reste R" aufweist;
• R'" = organischer Rests, der ausgewählt ist aus der Gruppe bestehend aus: Wasserstoff, Halogen oder Deuterium, sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen
• optional kann der Kupfer(I)komplex eine FG = Funktions-Gruppe (FG) als weiteren Substituenten aufweisen, die entweder direkt oder über geeignete Brücken an den N∩L -Substituenten gebunden ist, wobei die Funktionsgruppe ausgewählt ist aus der Gruppe bestehend aus Elektronenleiter, Lochleiter und Gruppen, die die Löslichkeit des Komplexes verändern, insbesondere die Löslichkeit in organischen Lösungsmitteln erhöhen;
• "*" kennzeichnet das Atom, das die Komplexbindung eingeht; und
• "#" kennzeichnet das Atom, das die Bindung mit der zweiten chemischen Einheit vermittelt;
wobei der Kupfer(I)komplex optional
- einen ΔE(S₁-T₁)-Wert zwischen dem untersten angeregten Singulett (S₁)- und dem darunter liegenden Triplett (T₁)-Zustand von kleiner als 2500 cm⁻¹ aufweist;
- eine Emissionslebensdauer von höchstens 20 µs aufweist;
- eine Emissionsquantenausbeuten von größer 40 % aufweist, und/oder
- eine Löslichkeit in organischen Lösungsmitteln von mindestens 1 g/L aufweist.

2. Kupfer(I)komplex nach Anspruch 1, wobei der N∩L Ligand ein optional substituierter Bisheteroaromat ist, der bevorzugt in ortho-Position zur Koordinationsstelle mit Substituenten wie Alkyl [CH₃-(CH₂)ₙ-] (n = 1 - 20) (optional verzweigt) oder Aryl (insbesondere Phenyl) substituiert ist.

3. Kupfer(I)komplex nach Anspruch 1 oder 2, wobei der sterisch anspruchsvolle Substituent R" zur Verhinderung der Planarisierung des Komplexes im angeregten Zustand ausgewählt ist aus der Gruppe bestehend aus:
Alkylresten -(CH₂)ₙ-CH₃ (n = 0 - 20) (optional verzweigt), Arylresten mit 6 - 20 Kohlenstoffatomen (z. B. -OPh), Alkoxyresten -O-(CH₂)ₙ-CH₃ (n = 0 - 20), Aryloxyresten (z. B. -OPh) und Silanresten (z. B -SiMe₃), ungesättigten Gruppen wie Alkenyl- und Alkinyl-Gruppen handeln, die wiederum optional mit Alkyl-Gruppen, Halogenen (F, Cl, Br, I), oder Deuterium, Silan- (-SiR""₃) oder Ethergruppen -OR"" (R"" definiert wie R") substituiert sind;
wobei die Alkyl- und Arylreste optional substituiert und/oder zu anellierten Ringsystemen fusioniert sind.

4. Kupfer(I)komplex nach Anspruch 1 bis 3, wobei der sterisch anspruchsvolle Substituent R" die Löslichkeit des Kupfer(I)komplexes in organischen Lösungsmitteln erhöht und/oder die Loch- oder die Elektronenleitung erhöht.

5. Kupfer(I)komplex nach Anspruch 1 bis 4, wobei der sterisch anspruchsvolle Substituent R" zur Verhinderung der Planarisierung des Komplexes im angeregten Zustand eine aliphatische Gruppe in ortho-Position zur Koordinationsstelle ist.

6. Kupfer(I)komplex nach Anspruch 1 bis 5, wobei der Kupfer(I)komplex
- einen ΔE(Si-T₁)-Wert von kleiner als 1500 cm⁻¹, bevorzugt von kleiner als 1000 cm⁻¹, besonders bevorzugt von kleiner als 500 cm⁻¹ aufweist;
- eine Emissionsquantenausbeuten von größer 40 %, bevorzugt größer 60 %, besonders bevorzugt größer 70 % aufweist;
- eine Emissionslebensdauer von höchstens 10 µs, bevorzugt kleiner 6 µs, besonders bevorzugt kleiner 3 µs aufweist; und/oder
- eine Löslichkeit in organischen Lösungsmitteln von mindestens 10 g/L aufweist.

7. Verwendung eines Kupfer(I)komplexes nach Anspruch 1 bis 6 zur Emission von Licht, insbesondere in einer Emitterschicht in einer opto-elektronischen Vorrichtung.

8. Verfahren zur Herstellung einer opto-elektronischen Vorrichtung,
wobei ein Kupfer(I)komplex nach Anspruch 1 bis 7 verwendet wird.

9. Verfahren zur Herstellung einer opto-elektronischen Vorrichtung nach Anspruch 8,
wobei die Herstellung nass-chemisch erfolgt und das Verfahren die folgenden Schritte aufweist:
- Aufbringung eines in einem ersten Lösungsmittel gelösten ersten Emitterkomplexes auf einen Träger, und
- Aufbringung eines in einem zweiten Lösungsmittel gelösten zweiten Emitterkomplexes auf den Träger;
wobei
- der erste Emitterkomplexes nicht in dem zweiten Lösungsmittel löslich ist und
- der zweite Emitterkomplexes nicht in dem ersten Lösungsmittel löslich ist;
und wobei der erste Emitterkomplex und/oder der zweite Emitterkomplex ein Kupfer(I)komplex nach Anspruch 1 bis 6 ist.

10. Verfahren nach Anspruch 9, wobei das Verfahren weiterhin den folgenden Schritt aufweist:
- Aufbringung eines in dem ersten Lösungsmittel oder in einem dritten Lösungsmittel gelösten dritten Emitterkomplexes auf den Träger,
wobei der dritte Kupfer(I)komplex ein Kupfer(I)komplex nach Anspruch 1 bis 6 ist.

11. Verfahren nach Anspruch 10, wobei die opto-elektronische Vorrichtung eine Weißlicht-OLED ist, wobei
- der erste Emitterkomplexe ein Rotlichtemitter ist,
- der zweite Emitterkomplexe ein Grünlichtemitter ist und
- der dritte Emitterkomplexe ein Blaulichtemitter ist.

12. Opto-elektronische Vorrichtung, aufweisend einen Kupfer(I)komplex nach den Ansprüchen 1 bis 7.

13. Opto-elektronische Vorrichtung nach Anspruch 12,
wobei der Anteil des Kupfer(I)komplexes in einer Emitterschicht 2 bis 100 Gew.-%,
bevorzugt 4 bis 50 Gew.-%, bezogen auf das Gesamtgewicht der Emitterschicht, beträgt.

14. Opto-elektronische Vorrichtung nach Anspruch 12 oder 13 in Form einer organischen Leuchtdiode (OLED), **gekennzeichnet durch** einen Kupfer(I)komplex nach Anspruch 1 bis 7 aufweisende Emitterschicht, wobei der Anteil des Kupfer(I)komplexes in der Emitterschicht zwischen 2 bis 100 Gew.-%, bevorzugt 4 bis 50 Gew.-%, bezogen auf das Gesamtgewicht der Emitterschicht, beträgt.

15. Verwendung nach Anspruch 7, Verfahren nach Anspruch 8 bis 10, opto-elektronische Vorrichtung nach Anspruch 12 oder 13 wobei die opto-elektronische Vorrichtung ausgewählt ist aus der Gruppe bestehend aus organischen Leuchtidioden (OLEDs), lichtemittierenden elektrochemischen Zellen (LEECs oder LECs), OLED-Sensoren, insbesondere nicht hermetisch nach außen abgeschirmten Gas- und Dampf-Sensoren, optischen TemperaturSensoren, organischen Solarzellen (OSCs), organischen Feldeffekttransistoren, organischen Lasern, organischen Dioden, organischen Photodioden und "down conversion" Systemen.

16. Verfahren zur Auswahl von Kupfer(I)komplexen nach Anspruch 1 bis 6, deren ΔE(S₁-T₁)-Wert zwischen dem untersten angeregten Singulett- (S₁) und dem darunter liegenden Triplett-Zustand (T₁) kleiner als 2500 cm⁻¹, bevorzugt kleiner als 1500 cm⁻¹, besonders bevorzugt kleiner als 1000 cm⁻¹, ganz besonders bevorzugt kleiner 500 cm⁻¹ ist, **gekennzeichnet durch**
- Bestimmung des ΔE(S₁-T₁)-Wertes eines Kuper(I)komplexes
- mittels einer ab-initio Molekülrechnung oder
- mittels Messung der Temperaturabhängigkeit der Fluoreszenz- und der Phosphoreszenz-Intensität oder
- mittels der Messung der Temperaturabhängigkeit der Emissionslebensdauer und
- Ermittlung der Kupfer(I)komplexe, deren ΔE(S₁-T₁)-Wert kleiner als 2500 cm⁻¹, bevorzugt kleiner als 1500 cm⁻¹, besonders bevorzugt kleiner als 1000 cm⁻¹, ganz besonders bevorzugt kleiner 500 cm⁻¹ ist.

## Claims

1. Neutral mononuclear copper(I) complex for the emission of light comprising a structure according to formula A 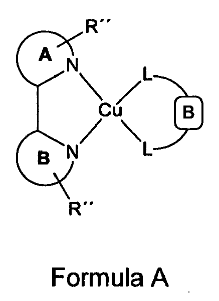 wherein 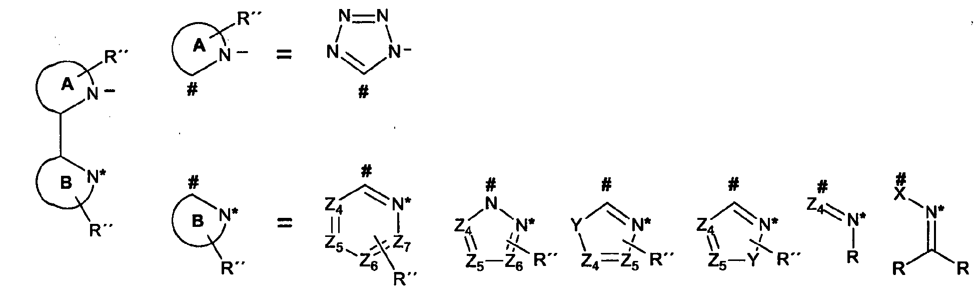 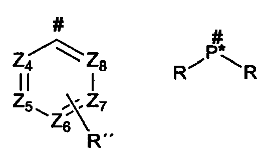 wherein:
• M is Cu(I);
• L-B-L: a neutral, bidentate ligand, preferably a phosphinyl or arsinyl group E*(R1)(R2), with E = P or As; R1, R2 can each independently from each other be hydrogen, halogen or deuterium or substituents which are bound via oxygen (-OR"'), nitrogen (-NR'"₂) or silicon atoms (-SiR"'₃) as well as alkyl-(also branched or cyclic), aryl, heteroaryl, alkenyl, alkinyl groups or substituted alkyl (also branched or cyclic), aryl, heteroaryl and alkenyl groups with substituents such as halogens or deuterium, alkyl groups (also branched or cyclic), and further generally known donor and acceptor groups such as, for example, amines, carboxylates and their esters, and CF₃-groups, which is bound to another group L via a bridge B and thereby forms a bidentate ligand, wherein the bridge B is an alkylene or arylene group or a combination of both, or -O-, -NR"'- or -SiR"'₂-, wherein the groups R1-R2 optionally form annulated ring systems;
• Z4-Z7: consists of N or the fragment CR,
with R = organic group, selected from the group consisting of: hydrogen, halogen or deuterium or substituents which are bound via oxygen (-OR"'), nitrogen (-NR"'₂), silicon (-SiR'"₃) or phosphorous atoms (PR'"₂) as well as alkyl- (also branched or cyclic), aryl, heteroaryl, alkenyl, alkinyl groups or substituted alkyl (also branched or cyclic), aryl, heteroaryl and alkenyl groups with substituents such as halogens or deuterium, alkyl groups (also branched or cyclic), and further generally known donor and acceptor groups such as, for example, amines, carboxylates and their esters, and CF₃-groups;
• X is either CR"'₂ or NR"';
• Y is either O, S or NR'";
• Z8 consists of the fragment CR',
with R' = OR"', NR"'₂ or PR'"₂, wherein the bond to the Cu atom is formed via these groups;
• R" is a sterically demanding substituent, preferably in ortho position to the coordination point, which prevents a change in geometry in the direction of a planarization of the complex in an excited state, preferably an alkyl group-(CH₂)ₙ-CH₃ (n = 0 - 20) (also branched), an aryl group with 6 - 20 carbon atoms (e.g. -Ph), alkoxy group -O-(CH₂)ₙ-CH₃ (n = 0 - 20), an aryloxy group (e.g. -OPh) or a silane group (e.g -SiMe₃), wherein the alkyl and aryl groups can also be substituted (e.g. with halogens, deuterium, alkoxy or silane groups) and optionally lead to annulated ring systems, wherein formula A comprises no, one or two groups R";
• R'" = organic rest which is selected from the group consisting of: hydrogen, halogen or deuterium, as well as alkyl- (also branched or cyclic), aryl, heteroaryl, alkenyl, alkinyl groups or substituted alkyl (also branched or cyclic), aryl, heteroaryl and alkenyl groups with substituents such as halogens or deuterium, alkyl groups (also branched or cyclic), and further generally known donor and acceptor groups such as, for example, amines, carboxylates and their esters, and CF₃-groups;
• optionally the copper(I) complex comprises a FG = function group as a further substituent which is either bound directly or via suitable bridges to the N∩L - substituent, wherein the function group is selected from the group consisting of electron conductor, hole conductor and groups which change the solubility of the complex, in particular increase the solubility in organic solvents;
• "*" indicates the atom which forms the complex bond; and
• indicates the atom which forms the bond with the second chemical unit;
wherein the copper (I) complex optionally
- has a ΔE(S₁-T₁)-value between the lowest excited singlet (S₁) state and the triplet (T₁) state below it of smaller than 2500 cm⁻¹;
- an emission lifetime of at the most 20 µs;
- an emission quantum yield of greater than 40 %, and/or
- a solubility in organic solvents of at least 1 g/L.

2. Copper(I) complex according to claim 1, wherein the N∩L ligand is an optionally substituted bisheteroarmatic compound which preferably is substituted in position ortho to the coordination point with substituents such as alkyl [CH₃-(CH₂)ₙ-] (n = 1-20) (optionally branched) or aryl (particularly phenyl).

3. Copper(I) complex according to claim 1 or 2, wherein the sterically demanding substituent R" for inhibiting the planarization of the complex in an excited state is selected from the group consisting of:
alkyl groups -(CH₂)ₙ-CH₃ (n = 0 - 20) (optionally branched), aryl groups with 6 - 20 carbon atoms (e.g. -OPh), alkoxy groups -O-(CH₂)ₙ-CH₃ (n = 0 - 20), aryloxy groups (e.g. -OPh) and silane groups (e.g -SiMe₃), unsaturated groups such as alkenyl and alkinyl groups which again are optionally substituted with alkyl groups, halogens (F, Cl, Br, I), or deuterium, silane (-SiR""₃) or ether groups -OR"" (R"" defined like R");
wherein the alkyl and aryl groups are optionally substituted and/or are fused to annulated ring systems.

4. Copper(I) complex according to claim 1 to 3, wherein the sterically demanding substituent R" increases the solubility of the copper(I) complex in organic solvents and/or increases the hole or electron conductivity.

5. Copper(I) complex according to claim 1 to 4, wherein the sterically demanding substituent R" for inhibiting the planarization of the complex in an excited state is an aliphatic group in ortho position to the coordination point.

6. Copper(I) complex according to claim 1 to 5, wherein the copper(I) complex
- has a ΔE(S₁-T₁)-value of smaller than 1500 cm⁻¹, preferably smaller than 1000 cm⁻¹, particularly preferably of smaller than 500 cm⁻¹;
- an emission quantum yield of greater than 40 %, preferably of greater than 60 %, particularly preferably of greater than 70 %;
- an emission lifetime of at the most 10 µs, preferably of smaller than 6 µs, particularly preferably of smaller than 3 µs; and/or
- a solubility in organic solvents of at least 10 g/L.

7. Use of a copper(I) complex according to claim 1 to 6 for the emission of light, in particular in an emitter layer in an optoelectronic device.

8. A method for manufacturing an optoelectronic device, wherein a copper(I) complex according to claims 1 to 7 is used.

9. The method for manufacturing an optoelectronic device according to claim 8, wherein the manufacturing is performed wet-chemically and the method comprises the following steps:
- depositing a first emitter complex that is dissolved in a first solvent onto a carrier, and
- depositing a second emitter complex that is dissolved in a second solvent onto the carrier, wherein;
- the first emitter complex is not soluble in the second solvent, and
- the second emitter complex is not soluble in the first solvent;
and wherein the first emitter complex and/or the second emitter complex is a copper(I) complex according to claims 1 to 6.

10. The method according to claim 9, wherein the method comprises furthermore the following step:
- depositing a third emitter complex onto the carrier that is dissolved in the first solvent or a third solvent,
wherein the third copper(I) complex is a copper(I)complex according to claims 1 to 6.

11. The method according to claim 10, wherein the optoelectronic device is a white-light OLED, wherein
- the first emitter complex is a red-light emitter,
- the second emitter complex is a green-light emitter and
- the third emitter complex is a blue-light emitter.

12. Optoelectronic device, comprising a copper(I) complex according to claims 1 to 7.

13. Optoelectronic device according to claim 12,
wherein the fraction of the copper(I)complex in the emitter layer is 2 to 100 weight-%, preferably 4 to 50 weight.-%, in respect to the total weight of the emitter layer.

14. Optoelectronic device according to claim 12 or 13 in the form of an organic light emitting diode (OLED), **characterized by** an emitter layer that comprises a copper(I) complex according to claim 1 to 7, wherein the fraction of the copper(I) complex in the emitter layer is between 2 to 100 weight-%, preferably 4 to 50 weight-%, in respect to the total weight of the emitter layer.

15. Use according to claim 7, method according to claim 8 to 10, optoelectronic device according to claim 12 or 13 wherein the optoelectronic device is selected from the group consisting of organic light emitting diodes (OLEDs), light emitting electrochemical cells (LEECs or LECs), OLED-sensors, especially gas and vapor sensors which are not hermetically screened from the outside, optical temperature sensors, organic solar cells (OSCs), organic field-effect transistors, organic lasers, organic diodes, organic photo diodes and "down conversion" systems.

16. Method for selecting copper(I) complexes according to claim 1 to 6, whose ΔE(S₁-T₁)-value between the lowest exited singlet state (S₁) and the triplet state (T₁) below it is smaller than 2500 cm⁻¹, preferably smaller than 1500 cm⁻¹, particularly preferred smaller than 1000 cm⁻¹, exceptionally preferred smaller 500 cm⁻¹, **characterized by**
- determining the ΔE(S₁-T₁)-value of a copper(I) complex
- by means of an up-initio molecular calculation or
- by means of measurement of the temperature dependence of the fluorescence and phosphorescence intensity or
- by means of the measurement of the temperature dependence of the emission lifetime, and
- determining the copper(I) complexes whose ΔE(S₁-T₁)-value is smaller than 2500 cm⁻¹, preferably smaller than 1500 cm⁻¹, particularly preferred smaller than 1000 cm⁻¹ , even more preferred smaller than 500 cm⁻¹.

## Revendications

1. Complexe du cuivre (I) neutre à un noyau pour l'émission de lumière, présentant une structure selon la formule A 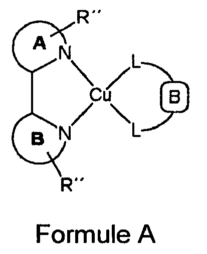 dans laquelle 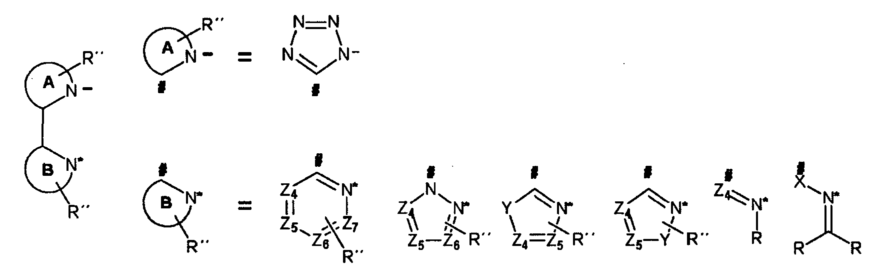 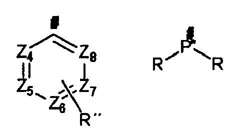 où
- M représente Cu (I) ;
- L-B-L : un ligand neutre, bidentate, de préférence un radical phosphanyle ou arsanyle E*(R1)(R2), E = P ou As; R1, R2 peuvent représenter, à chaque fois indépendamment l'un de l'autre, hydrogène, halogène ou deutérium ou des substituants, qui sont liés via des atomes d'oxygène (-OR"'), d'azote (-NR"'₂) ou de silicium (-SiR"'₃) ainsi que des groupes alkyle (également ramifiés ou cycliques), aryle, hétéroaryle, alcényle, alcynyle ou des groupes alkyle (également ramifiés ou cycliques), aryle, hétéroaryle et alcényle substitués par des substituants tels que des halogènes ou du deutérium, des groupes alkyle (également ramifiés ou cycliques) et d'autres groupes donneurs et accepteurs généralement connus, tels que par exemple des amines, des carboxylates et leurs esters, et des groupes CF₃, qui est relié via un pont B à un autre radical L et qui forme de ce fait un ligand bidentate, le pont B étant un groupe alkylène ou arylène ou une combinaison des deux, ou représentant -O-, -NR"'- ou -SiR"'₂-, les groupes R1-R2 formant éventuellement des systèmes cycliques annelés ;
- Z4-Z7 : sont constitués de N ou par le fragment CR,
avec R = un radical organique qui est choisi dans le groupe constitué par : hydrogène, halogène ou deutérium ou des groupes qui sont liés via des atomes d'oxygène (-OR"'), d'azote (-NR"'₂), de silicium (-SiR"'₃) ou de phosphore (-PR"'₂) ainsi que des groupes alkyle (également ramifiés ou cycliques), aryle, hétéroaryle, alcényle, alcynyle ou des groupes alkyle (également ramifiés ou cycliques), aryle, hétéroaryle et alcényle substitués par des substituants tels que des halogènes ou du deutérium, des groupes alkyle (également ramifiés ou cycliques), et d'autres groupes donneurs et accepteurs généralement connus, tels que par exemple les amines, les carboxylates et leurs esters, et des groupes CF₃ ;
- X représente soit CR"'₂ soit NR'" ;
- Y représente soit O, soit S soit NR"' ;
- Z8 est constitué par le fragment CR',
avec R' = OR"', NR"'₂ ou PR"'₂, la liaison à l'atome de Cu s'effectuant alors via ces groupes ;
- R" est un substituant stériquement encombré, de préférence en position ortho par rapport à la position de coordination, qui empêche une modification de géométrie dans le sens d'un aplanissement du complexe à l'état excité, de préférence un radical alkyle -(CH₂)ₙ-CH₃ (n = 0 - 20) (également ramifié), un radical aryle comprenant 6-20 atomes de carbone (par exemple -Ph), un radical alcoxy -O-(CH₂)ₙ-CH₃ (n = 0 - 20), un radical aryloxy (par exemple -OPh) ou un radical silane (par exemple -SiMe₃), les radicaux alkyle et aryle pouvant également être substitués (par exemple par des halogènes, du deutérium, des groupes alcoxy ou silane) et conduisant éventuellement à des systèmes cycliques annelés,
la formule A ne présentant pas de radicaux R" ou présentant un ou deux radicaux R" ;
- R'" = un radical organique qui est choisi dans le groupe constitué par : hydrogène, halogène ou deutérium ainsi que des groupes alkyle (également ramifiés ou cycliques), aryle, hétéroaryle, alcényle, alcynyle ou des groupes alkyle (également ramifiés ou cycliques), aryle, hétéroaryle et alcényle substitués par des substituants tels que des halogènes ou du deutérium, des groupes alkyle (également ramifiés ou cycliques), et d'autres groupes donneurs et accepteurs généralement connus, tels que par exemple les amines, les carboxylates et leurs esters, et des groupes CF₃ ;
- éventuellement, le complexe du cuivre (I) peut présenter un GF = groupe fonctionnel (GF) comme autre substituant, qui est lié, soit directement, soit via des ponts appropriés au substituant N∩L, le groupe fonctionnel étant choisi dans le groupe constitué par les conducteurs d'électrons, les conducteurs de trous et les groupes qui modifient la solubilité du complexe, en particulier qui augmentent la solubilité dans des solvants organiques ;
- "*" caractérise l'atome, qui participe à une liaison complexe ; et
- caractérise l'atome qui intervient dans la liaison avec la deuxième unité chimique ;
le complexe de cuivre (I) présentant éventuellement
- une valeur ΔE(S₁-T₁) entre l'état de singulet excité le plus bas (S₁)- et l'état de triplet inférieur à celui-ci (T₁) inférieure à 2500 cm⁻¹ ;
- une durée de vie d'émission d'au plus 20 µs ;
- un rendement de quanta d'émission supérieur à 40% et/ou
- une solubilité dans des solvants organiques d'au moins 1 g/l.

2. Complexe de cuivre (I) selon la revendication 1, le ligand N∩L étant un bis-hétéroaromatique éventuellement substitué, qui est de préférence substitué en position ortho par rapport à la position de coordination par des substituants tels qu'alkyle [CH₃-(CH₂)ₙ-] (n = 1 - 20) (éventuellement ramifiés) ou aryle (en particulier phényle).

3. Complexe de cuivre (I) selon la revendication 1 ou 2, le substituant stériquement encombré R" pour empêcher l'aplanissement du complexe à l'état excité étant choisi dans le groupe constitué par :
des radicaux alkyle -(CH₂)ₙ-CH₃ (n = 0 - 20) (éventuellement ramifiés), des radicaux aryle comprenant 6-20 atomes de carbone (par exemple -OPh), des radicaux alcoxy -O-(CH₂)ₙ-CH₃ (n = 0 - 20), des radicaux aryloxy (par exemple -OPh) et des radicaux silane (par exemple -SiMe₃), des groupes insaturés tels que des groupes alcényle et alcynyle, qui sont à leur tour éventuellement substitués par des groupes alkyle, des halogènes (F, Cl, Br, I) ou du deutérium, des groupes silane (-SiR""₃) ou éther -OR"" (R"" étant défini comme R") ;
les radicaux alkyle et aryle étant éventuellement substitués et/ou fusionnés en systèmes cycliques annelés.

4. Complexe de cuivre (I) selon la revendication 1 à 3, le substituant R" stériquement encombré augmentant la solubilité du complexe de cuivre (I) dans les solvants organiques et/ou augmentant la conductivité des trous ou des électrons.

5. Complexe de cuivre (I) selon la revendication 1 à 4, le substituant stériquement encombré R" pour empêcher l'aplanissement du complexe à l'état excité étant un groupe aliphatique en position ortho par rapport à la position de coordination.

6. Complexe de cuivre (I) selon la revendication 1 à 5, le complexe de cuivre (I)
- présentant une valeur ΔE(S₁-T₁) inférieure à 1500 cm⁻¹, de préférence inférieure à 1000 cm⁻¹, de manière particulièrement préférée inférieure à 500 cm⁻¹ ;
- présentant un rendement de quanta d'émission supérieur à 40%, de préférence supérieur à 60%, de manière particulièrement préférée supérieur à 70% ;
- présentant une durée de vie d'émission d'au plus 10 µs, de préférence inférieure à 6 µs, de manière particulièrement préférée inférieure à 3 µs ; et/ou
- présentant une solubilité dans des solvants organiques d'au moins 10 g/l.

7. Utilisation d'un complexe de cuivre (I) selon la revendication 1 à 6 pour l'émission de lumière, en particulier dans une couche émettrice dans un dispositif optoélectronique.

8. Procédé pour la fabrication d'un dispositif optoélectronique, un complexe de cuivre (I) selon la revendication 1 à 7 étant utilisé.

9. Procédé pour la fabrication d'un dispositif optoélectronique selon la revendication 8, la fabrication étant réalisée par voie chimique humide et le procédé présentant des étapes suivantes :
- application d'un premier complexe d'émission dissous dans un premier solvant sur un support, et
- application d'un deuxième complexe d'émission dissous dans un deuxième solvant sur le support,
- le premier complexe d'émission n'étant pas soluble dans le deuxième solvant et
- le deuxième complexe d'émission n'étant pas soluble dans le premier solvant,
et le premier complexe d'émission et/ou le deuxième complexe d'émission étant un complexe du cuivre (I) selon la revendication 1 à 6.

10. Procédé selon la revendication 9, le procédé comprenant en outre l'étape suivante :
- application d'un troisième complexe d'émission dissous dans le premier solvant ou dans un troisième solvant sur le support,
le troisième complexe du cuivre (I) étant un complexe du cuivre (I) selon la revendication 1 à 6.

11. Procédé selon la revendication 10, le dispositif optoélectronique étant une DELO à lumière blanche,
- le premier complexe d'émission étant un émetteur de lumière rouge,
- le deuxième complexe d'émission étant un émetteur de lumière verte et
- le troisième complexe d'émission étant un émetteur de lumière bleue.

12. Dispositif optoélectronique, présentant un complexe du cuivre (I) selon les revendications 1 à 7.

13. Dispositif optoélectronique selon la revendication 12, la proportion du complexe de cuivre (I) dans une couche émettrice étant de 2 à 100% en poids, de préférence de 4 à 50% en poids, par rapport au poids total de la couche émettrice.

14. Dispositif optoélectronique selon la revendication 12 ou 13 sous forme d'une diode électroluminescente organique (DELO), **caractérisé par** une couche émettrice présentant un complexe du cuivre (I) selon la revendication 1 à 7, la proportion du complexe du cuivre (I) dans la couche émettrice étant de 2 à 100% en poids, de préférence de 4 à 50% en poids, par rapport au poids total de la couche émettrice.

15. Utilisation selon la revendication 7, procédé selon la revendication 8 à 10, dispositif optoélectronique selon la revendication 12 ou 13, le dispositif optoélectronique étant choisi dans le groupe constitué par les diodes électroluminescentes organiques (DELO), les cellules électrochimiques émettrices de lumière (CEEL ou CEL), les capteurs DELO, en particulier des capteurs de gaz et de vapeur non hermétiquement protégés par rapport à l'extérieur, les capteurs optiques de température, les cellules solaires organiques (CSO), les transistors organiques à effet de champ, les lasers organiques, les diodes organiques, les photodiodes organiques et les systèmes de "down conversion".

16. Procédé pour la sélection de complexes de cuivre (I) selon la revendication 1 à 6, dont la valeur ΔE(S₁-T₁) entre l'état singulet excité le plus bas (S₁) et l'état de triplet inférieur à celui-ci (T₁) est inférieure à 2500 cm⁻¹, de préférence inférieure à 1500 cm⁻¹, de manière particulièrement préférée inférieure à 1000 cm⁻¹, de manière tout particulièrement préférée inférieure à 500 cm⁻¹, **caractérisé par**
- la détermination de la valeur ΔE(S₁-T₁) d'un complexe du cuivre (I)
- au moyen d'un calcul moléculaire ab initio ou
- au moyen d'une mesure de la dépendance de la température de l'intensité de fluorescence et de phosphorescence ou
- au moyen de la mesure de la dépendance de la durée de vie d'émission et
- la détermination des complexes du cuivre (I) dont la valeur ΔE(S₁-T₁) est inférieure à 2500cm⁻¹, de préférence inférieure à 1500 cm⁻¹, de manière particulièrement préférée inférieure à 1000 cm⁻¹, de manière tout particulièrement préférée inférieure à 500 cm⁻¹.
